# EUROPEAN PATENT APPLICATION

(11) **EP 4 832 675 A1**
(43) Date of publication of application: **28.10.2026**
(21) Application number: 24907965.8
(22) Date of filing: 11.12.2024
(51) Int. Cl.: H05K 3/28, H05K 1/11, H05K 1/14, H05K 1/18

(54) **FLEXIBLE CIRCUIT BOARD, COF MODULE, AND ELECTRONIC DEVICE COMPRISING SAME**

(30) Priority: 18.12.2023 KR 20230184917; 05.01.2024 KR 20240001916
(71) Applicant: LG Innotek Co., Ltd., Seoul 07796 (KR)
(72) Inventor: SHIN, Jae Young, Seoul 07796 (KR); YOO, Dae Sung, Seoul 07796 (KR); KIM, Hyun Soo, Seoul 07796 (KR); PARK, Sang Hun, Seoul 07796 (KR); YANG, Gi Uk, Seoul 07796 (KR)
(74) Representative: DREISS Patentanwälte PartG mbB
(86) International application number: PCT/KR2024/020237
(87) International publication number: WO 2025/135681

(57) **Abstract**

A flexible circuit board according to an embodiment includes a substrate; a conductive pattern on the substrate; and a protective layer on the conductive pattern, wherein the conductive pattern includes a first circuit pattern connected to a circuit board; a second circuit pattern connected to a display panel; and a plurality of outermost patterns, wherein the plurality of outermost patterns include at least one of a circuit pattern and a dummy pattern, wherein the substrate includes a first direction in which the display panel and the circuit board face each other and a second direction perpendicular to the first direction, wherein the plurality of outermost patterns includes a first outermost pattern and a second outermost pattern disposed at an outermost side in the second direction, wherein the protective layer includes a first end which is one end in the first direction, wherein the first outermost pattern includes a first protruding portion, wherein the second outermost pattern includes a third protruding portion, and wherein the first end overlaps the first protruding portion and the third protruding portion.

## Description

### Technical Field

An embodiment relates to a flexible circuit board, a COF module and an electronic device including the same.

### Background Art

Recently, various electronic products are becoming thinner and smaller. Accordingly, it is required to mount semiconductor chips in a narrow region of the electronic product at a high density.

A COF (Chip On Film) includes a circuit board and a chip disposed on the circuit board. The circuit board is flexible. That is, the COF is a flexible circuit board. Accordingly, the COF is applied to a flexible display. For example, the COF can be applied to various wearable electronic devices. In addition, the COF has a fine pitch. Accordingly, the COF is applied to a display having a high resolution.

The chip includes a semiconductor chip. For example, the chip can be an integrated circuit (IC) chip or a large scale integrated circuit (LSI) chip.

The chip is connected to an external circuit board and a display panel through a circuit pattern. For example, pad portions are provided at each one end and other end of the circuit pattern. Either pad portion is electrically connected to a terminal of the chip. Another pad portion is connected to terminals of the external circuit board and the display panel. Accordingly, the chip, the external circuit board, and the display panel are electrically connected through the COF. Accordingly, a signal is transmitted to the display panel through the circuit pattern.

A protective layer is disposed on the circuit pattern. The protective layer is disposed on a region excluding a region where the pad part is disposed.

The protective layer is formed by a squeegee process. During the process, a deviation of the protective layer may occur. That is, the protective layer may not be disposed at a desired location, but may be disposed at an undesired location. Accordingly, the protective layer may not be disposed on a part of the wiring part of the circuit pattern. In addition, the protective layer may be disposed on a part of the pad part of the circuit pattern.

Therefore, a new structure of a flexible circuit board, a COF module, and an electronic device including the same that can solve the above problems are required.

As a patent related to the flexible circuit board, Korean Patent No. KR10-0618898 (2006.09.01) is disclosed.

### Disclosure

### Technical Problem

The embodiment provides a flexible circuit board having improved reliability and a COF module including the same.

### Technical Solution

A flexible circuit board according to an embodiment comprises a substrate; a conductive pattern on the substrate; and a protective layer on the conductive pattern, wherein the conductive pattern includes a first circuit pattern connected to a circuit board; a second circuit pattern connected to a display panel; and a plurality of outermost patterns, the plurality of outermost patterns include at least one of a circuit pattern and a dummy pattern, the substrate includes a first direction in which the display panel and the circuit board face each other and a second direction perpendicular to the first direction, the plurality of outermost patterns includes a first outermost pattern and a second outermost pattern disposed at an outermost side in the second direction, the protective layer includes a first end which is one end in the first direction, the first outermost pattern includes a first protruding portion, the second outermost pattern includes a third protruding portion, and the first end overlaps the first protruding portion and the third protruding portion.

In addition, the first circuit pattern includes a first pad part connected to a chip, a second pad part, and a first wiring part connecting the first pad part and the second pad part, the second circuit pattern includes a third pad part, a fourth pad part, and a second wiring part connecting the third pad part and the fourth pad part, the first outermost pattern includes a fifth pad part, a sixth pad part, and a third-first wiring part connecting the fifth pad portion and the sixth pad portion, and the second outermost pattern includes a seventh pad part, an eighth pad part, and a third-second wiring part connecting the seventh pad part and the eighth pad part.

In addition, the protective layer further includes a second end which is another end in the first direction, wherein the first outermost pattern includes a second protruding portion, wherein the second outermost pattern includes a fourth protruding portion, wherein the first protruding portion and the second protruding portion face each other in the first direction, wherein the third protruding portion and the fourth protruding portion face each other in the first direction, and wherein the second end overlaps the second protruding portion and the fourth protruding portion.

In addition, the first protruding portion includes a first-first protruding portion, a first-second protruding portion, and a first-third protruding portion, wherein the second protruding portion includes a second-first protruding portion, a second-second protruding portion, and a second-third protruding portion, wherein the third protruding portion includes a third-first protruding portion, a third-second protruding portion, and a third-third protruding portion, and wherein the fourth protruding portion includes a fourth-first protruding portion, a fourth-second protruding portion, and a fourth-third protruding portion.

In addition, the first-first protruding portion is connected to the fifth pad part, wherein the first-second protruding portion is connected to the third-first wiring part, wherein the first-third protruding portion is disposed between the first-first protruding portion and the first-second protruding portion, wherein a distance between the first-first protruding portion and the first-third protruding portion and a distance between the first-second protruding portion and the first-third protruding portion are 50um to 150um, and wherein the first end overlaps the first-third protruding portion.

In addition, the third-first protruding portion is connected to the seventh pad part, wherein the third-second protruding portion is connected to the third-second wiring part, wherein the third-third protruding portion is disposed between the third-first protruding portion and the third-second protruding portion, wherein a distance between the third-first protruding portion and the third-third protruding portion and a distance between the third-second protruding portion and the third-third protruding portion are 50um to 150um, and wherein the first end overlaps the third-third protruding portion.

In addition, the second-first protruding portion is connected to the sixth pad part, wherein the second-second protruding portion is connected to the third-first wiring part, wherein the second-third protruding portion is disposed between the second-first protruding portion and the second-second protruding portion, wherein a distance between the second-first protruding portion and the second-third protruding portion and a distance between the second-second protruding portion and the second-third protruding portion are 50um to 150um, and wherein the second end overlaps the second-third protruding portion.

In addition, the fourth-first protruding portion is connected to the eighth pad part, wherein the fourth-second protruding portion is connected to the third-second wiring part, wherein the fourth-third protruding portion is disposed between the fourth-first protruding portion and the fourth-second protruding portion, wherein a distance between the fourth-first protruding portion and the fourth-third protruding portion and a distance between the fourth-second protruding portion and the fourth-third protruding portion are 50um to 150um, and wherein the second end overlaps the fourth-third protruding portion.

In addition, the first circuit pattern includes an outermost pattern, wherein the second circuit pattern includes an outermost pattern, wherein the outermost pattern of the first circuit pattern includes a fifth protruding portion, wherein the outermost pattern of the second circuit pattern includes a sixth protruding portion, wherein the fifth protruding portion includes a fifth-first protruding portion, a fifth-second protruding portion, and a fifth-third protruding portion, and wherein the sixth protruding portion includes a sixth-first protruding portion, a sixth-second protruding portion, and a sixth-third protruding portion.

In addition, the fifth-first protruding portion is connected to the first pad part, wherein the fifth-second protruding portion is connected to the first wiring part, wherein the fifth-third protruding portion is disposed between the fifth-first protruding portion and the fifth-second protruding portion, wherein the sixth-first protruding portion is connected to the third pad part, wherein the sixth-second protruding portion is connected to the second wiring part, and wherein the sixth-third protruding portion is disposed between the sixth-first protruding portion and the sixth-second protruding portion.

In addition, the protective layer includes a third end adjacent to the first pad part and a fourth end adjacent to the third pad part, wherein the third end overlaps the fifth-third protruding portion, and wherein the fourth end overlaps the sixth-third protruding portion.

In addition, the substrate includes a first surface and a second surface opposite to the first surface, the first circuit pattern is disposed on the first surface, and the second circuit pattern is disposed on the first surface and the second surface.

### Advantageous Effects

The flexible circuit board according to the embodiment includes a first outermost pattern and a second outermost pattern.

The first outermost pattern and the second outermost pattern each include a plurality of protruding portions. A first end and a second end of the protective layer are aligned by the protruding portions. It is possible to check whether the first end and the second end are aligned by at least one protruding portion among the protruding portions.

In addition, when the first end and the second end of the protective layer is misaligned, a position of the protective layer can be adjusted by the protruding portions. That is, positions of the first end and the second end can be adjusted by at least one protruding portion among the protruding portions.

Therefore, the flexible circuit board according to the embodiment can align the protective layer without a separate alignment pattern. In addition, when an alignment of the protective layer is misaligned, a position of the protective layer can be easily adjusted through the protruding portion of the protective layer.

Accordingly, since the protective layer is disposed at a desired position, a problem of the protective layer not being disposed on the wiring part or a problem of the protective layer being disposed on the pad part can be solved.

Therefore, the flexible circuit board according to the embodiment can have improved reliability.

In addition, the flexible circuit board includes an outermost pattern. The outermost pattern is defined as a pattern including a region closest to a cutting line.

An outermost pattern including at least one pattern among a circuit pattern and a dummy pattern is disposed on a first surface. An outermost pattern including at least one pattern among a circuit pattern and a dummy pattern is disposed on a second surface.

The first protective layer and the second protective layer are disposed on outermost patterns on the first surface and the second surface.

A distance between an end of the first protective layer and the cutting line may be different from a distance between the second protective layer and the cutting line. Accordingly, a distance between the end of the first protective layer and the end of the second protective layer is different.

The embodiment controls the distance between the end of the first protective layer and the end of the second protective layer within a set range.

Therefore, a circuit pattern on the first surface or the second surface can be prevented from being exposed to an outside of the protective layer. Therefore, the flexible circuit board according to the embodiment has improved reliability.

### Description of Drawings

FIG. 1 is a top view of a flexible circuit board according to a first embodiment.
FIG. 2 is an enlarged view of region A of FIG. 1.
FIG. 3 is an enlarged view of region B of FIG. 1.
FIG. 4 is an enlarged view of region C of FIG. 1.
FIG. 5 is an enlarged view of region D of FIG. 1.
FIG. 6 is an enlarged view of region E of FIG. 1.
FIG. 7 is an enlarged view of region F of FIG. 1.

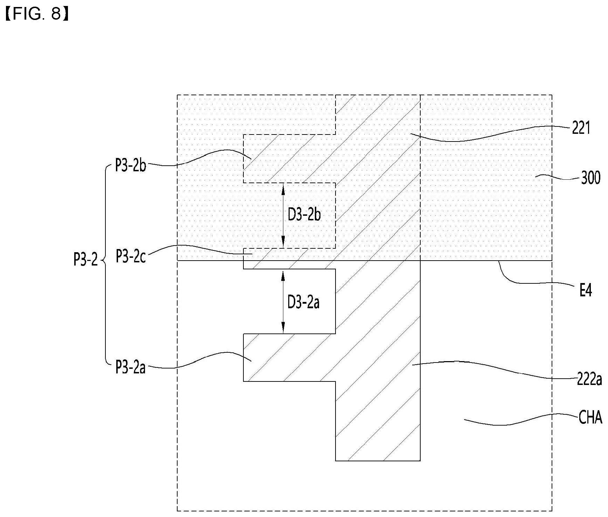

FIG. 8 is an enlarged view of region G of FIG. 1.

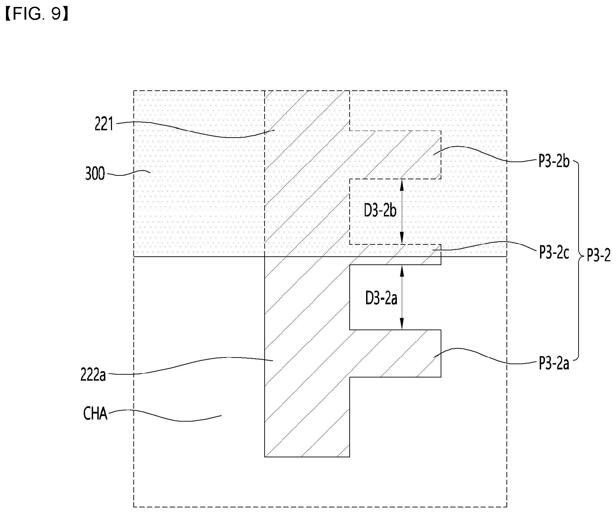

FIG. 9 is an enlarged view of region H of FIG. 1.
FIG. 10 and FIG. 11 are cross-sectional views taken along region A-A' of FIG. 1.
FIG. 12 is a top view of a flexible circuit board according to a second embodiment.
FIG. 13 is a bottom view of a flexible circuit board according to a second embodiment.
FIG. 14 is a view showing an enlarged view of region A of FIG. 12.
FIG. 15 is a view showing an enlarged view of region B of FIG. 12.
FIG. 16 is a view showing an enlarged view of region C of FIG. 13.
FIG. 17 is a view showing an enlarged view of region D of FIG. 13.
FIG. 18 is a view for explaining a problem due to a difference in an area of a protective layer.
FIGS. 19 to 21 are cross-sectional views taken along region A-A' of FIG. 12.
FIGS. 22 and 23 are cross-sectional views taken along region B-B' of FIG. 12.
FIG. 24 is a view for explaining a connection between a COF module and other members according to a first embodiment.
FIG. 25 is a view for explaining a connection between a COF module and other members according to a second embodiment.
FIGS. 26 to 28 are views for an electronic device including a flexible circuit board according to an embodiment.

### Modes of the Invention

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

In addition, in the following description, a first direction 1D may be defined as a width direction of the flexible circuit board, and a second direction 2D may be defined as a length direction of the flexible circuit board.

Hereinafter, a flexible circuit board according to an embodiment and a COF module including the same will be described with reference to the drawings.

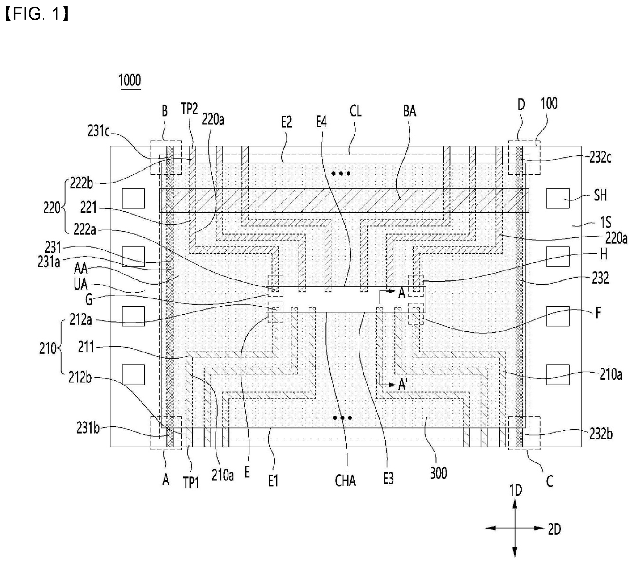

Referring to FIG. 1, a flexible circuit board 1000 according to an embodiment includes a substrate 100, a conductive pattern, and a protective layer 300.

The substrate 100 includes a first surface 1S and a second surface 2S opposite to the first surface 1S. The conductive pattern and the protective layer 300 are disposed on the first surface 1S.

The substrate 100 includes a cutting line CL. The flexible circuit board 1000 is cut along the cutting line CL. For example, the conductive pattern, the protective layer, and the chip are disposed on the substrate 100. Thereafter, the substrate 100 is cut along the cutting line CL. Accordingly, a COF module is manufactured. Accordingly, an edge of the COF module becomes the cutting line CL.

The substrate 100 includes an effective region AA and an ineffective region UA. In detail, the first surface 1S includes the effective region AA and the ineffective region UA.

The effective region AA and the ineffective region UA are separated by the cutting line CL. The effective region AA is an inner region of the cutting line CL. In addition, the ineffective region UA is an outer region of the cutting line CL.

The conductive pattern, the protective layer, and the chip are disposed on the effective region AA. In addition, a dummy pattern and a sprocket hole SH are disposed on the ineffective region UA. The dummy pattern increases a strength of the substrate 100. In addition, the flexible circuit board 1000 is rolled or unrolled in a roll-to-roll manner by the sprocket hole SH.

The substrate 100 includes a chip mounting region CHA. The chip mounting region CHA is disposed on the first surface 1S. The chip mounting region CHA is disposed on the effective region AA. The chip CH is disposed on the chip mounting region CHA. In addition, pad parts of the conductive pattern are disposed inside the chip mounting region CHA. In addition, the protective layer 300 is not disposed on the chip mounting region CHA.

The substrate 100 includes a flexible material. For example, the substrate 100 may include polyimide (PI). However, the embodiment is not limited thereto. The substrate 100 may include a polymer material including polyethylene terephthalate (PET) or polyethylene naphthalate (PEN). Accordingly, the flexible circuit board can be applied to various electronic devices including a curved display device.

The substrate 100 can have a thickness of 20um to 100um. For example, the substrate 100 can have a thickness of 25um to 50um. For example, the substrate 100 can have a thickness of 30um to 40um. If the thickness of the substrate 100 exceeds 100um, an overall thickness of the flexible circuit board increases. Accordingly, the flexible characteristic of the flexible circuit board can be reduced. In addition, if the thickness of the substrate 100 is less than 20um, the substrate 100 can be damaged by heat and pressure applied to the substrate 100 when the chip is mounted on the flexible circuit board.

The conductive pattern and the protective layer 300 are disposed on the substrate 100. In detail, the conductive pattern and the protective layer 300 are disposed on the first surface 1S. In detail, the conductive pattern and the protective layer 300 are disposed on at least one of the effective region AA and the ineffective region UA.

The conductive pattern includes a circuit pattern. The circuit pattern includes a first circuit pattern 210 and a second circuit pattern 220.

Referring to FIG. 1, the first circuit pattern 210 includes a first wiring part 211, a first pad part 212a, and a second pad part 212b. The first wiring part 211, the first pad part 212a, and the second pad part 212b may include a same material. In addition, the first wiring part 211, the first pad part 212a, and the second pad part 212b may be formed integrally.

The first pad part 212a is disposed inside the chip mounting region CHA. Accordingly, the first pad part 212a is connected to a terminal of the chip. Accordingly, the first circuit pattern 210 and the chip are connected.

The second pad part 212b is disposed outside the chip mounting region CHA. The second pad part 212b is connected to a pad part of the circuit board 3000. Accordingly, the first circuit pattern 210 and the circuit board 3000 are connected.

The first wiring part 211 is disposed between the first pad part 212a and the second pad part 212b. The first wiring part 211 connects the first pad part 212a and the second pad part 212b. Accordingly, the chip CH and the circuit board 3000 are connected. Therefore, a signal generated from the chip CH is transmitted to the circuit board 3000.

The first circuit pattern 210 may further include a test pad part. In detail, a first test pad part TP1 is disposed on the ineffective region UA. The first wiring part 211, the first pad part 212a, the second pad part 212b, and the first test pad part TP1 may be formed integrally.

Before connecting the circuit board and the second pad part 212b, the first circuit pattern 210 may be tested by the first test pad part TP1. For example, the first test pad part TP1 can be used to check whether the first circuit pattern is open or shorted.

The second circuit pattern 220 includes a second wiring part 221, a third pad part 222a, and a fourth pad part 222b. The second wiring part 221, the third pad part 222a, and the fourth pad part 222b may include a same material. In addition, the second wiring part 221, the third pad part 222a, and the fourth pad part 222b may be formed integrally.

The third pad part 222a is disposed inside the chip mounting region CHA. Accordingly, the third pad part 222a is connected to a terminal of the chip. Accordingly, the second circuit pattern 220 and the chip CH are connected.

The fourth pad part 222b is disposed outside the chip mounting region CHA. The fourth pad part 222b is connected to a pad part of an external display panel 4000. Accordingly, the second circuit pattern 220 and the display panel 4000 are connected.

The second wiring part 221 is disposed between the third pad part 222a and the fourth pad part 222b. The second wiring part 221 connects the third pad part 222a and the fourth pad part 222b. Accordingly, the chip CH and the display panel 4000 are connected. Therefore, a signal generated from the chip CH is transmitted to the display panel 4000.

The second circuit pattern 220 may further include a test pad part. In detail, a second test pad part TP2 is disposed in the ineffective region UA. The second test pad part TP2 is disposed outside the cutting line CL. The second test pad part TP2 is disposed on the ineffective region UA. The second wiring part 221, the third pad part 222a, the fourth pad part 222b, and the second test pad part TP2 may be formed integrally.

Before connecting the circuit board and the fourth pad part 222b, the second circuit pattern 220 may be tested by the second test pad part TP2. For example, the second test pad part TP2 can be used to check whether the second circuit pattern is open or shorted.

The protective layer 300 is disposed on the effective region of the first surface 1S. The protective layer 300 is disposed on the first surface 1S. Accordingly, the protective layer 300 is disposed on the first circuit pattern 210 and the second circuit pattern 220. The protective layer 300 is disposed on the first wiring part 211, the second wiring part 221, and the third wiring part 231. The protective layer 300 is not disposed on the first pad part 212a, the second pad part 212b, the third pad part 222a, and the fourth pad part 222b. In addition, the protective layer 300 is not disposed on the chip mounting region CHA.

The conductive pattern includes an outermost pattern 231 and 232. The outermost pattern may include a first outermost pattern 231 and a second outermost pattern 232.

The first outermost pattern 231 may be disposed at a left outermost side of the flexible circuit board 1000. The second outermost pattern 232 may be disposed at a right outermost side of the flexible circuit board 1000.

The first outermost pattern 231 and the second outermost pattern 232 may be circuit patterns. In detail, the first outermost pattern 231 and the second outermost pattern 232 may be circuit patterns through which a signal or current moves.

Alternatively, the first outermost pattern 231 and the second outermost pattern 232 may be dummy patterns. In detail, the first outermost pattern 231 and the second outermost pattern 232 may be dummy patterns through which no signal or current flows.

Alternatively, among the second outermost patterns 232, one outermost pattern may be a circuit pattern and the other outermost pattern may be a dummy pattern.

When the first outermost pattern 231 and the second outermost pattern 232 are circuit patterns, the first outermost pattern 231 and the second outermost pattern 231 may include a wiring part and a pad part, respectively.

Hereinafter, the first outermost pattern 231 and the second outermost pattern 232 are described as circuit patterns as an example.

The first outermost pattern 231 and the second outermost pattern 232 are disposed at an outermost side in the second direction 2D. The first outermost pattern 231 may include a third-first wiring part 231a, a fifth pad part 231b, and a sixth pad part 231c. In addition, the second outermost pattern 232 may include a third-second wiring part 232a, a seventh pad part 232b, and an eighth pad part 232c.

FIG. 1 illustrates that the fifth pad part 231b and the seventh pad part 232b are connected to the circuit board, and the sixth pad part 231c and the eighth pad part 232c are connected to the display panel.

However, the embodiment is not limited thereto. At least one of the first outermost pattern 231 and the second outermost pattern 231 may further include an additional pad part connected to the chip.

Hereinafter, FIG. 1 will be described as an example.

The protective layer 300 includes ends facing each other in the first direction 1D. In detail, the protective layer 300 includes a first end E1 adjacent to the second pad part 212b and a second end E2 adjacent to the fourth pad part 222b.

The first end E1 may be one end of the protective layer 300 disposed in the first direction 1D. In addition, the second end E2 may be another end of the protective layer 300 disposed in the first direction 1D.

The first end E1 and the second end E2 of the protective layer 300 are aligned by the outermost patterns 231 and 232.

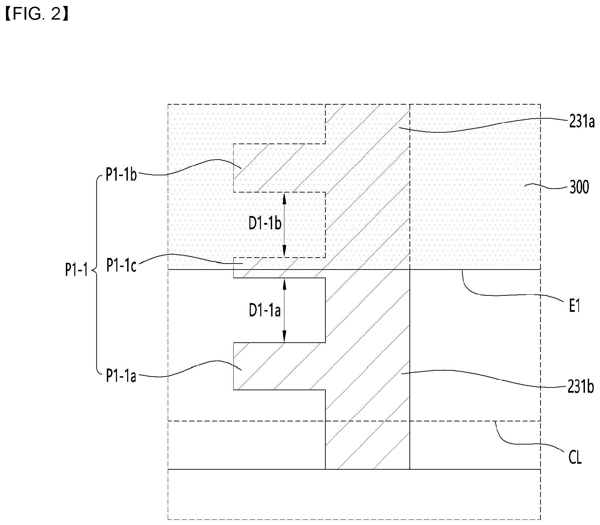

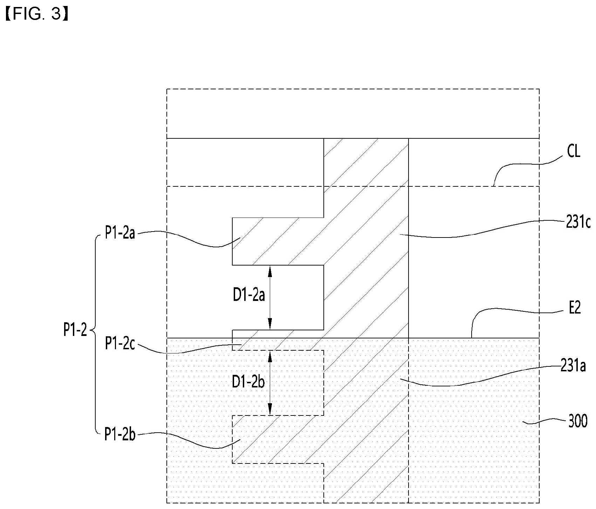

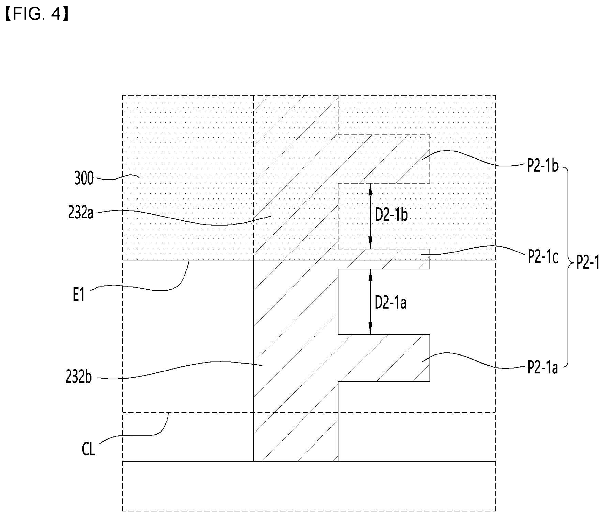

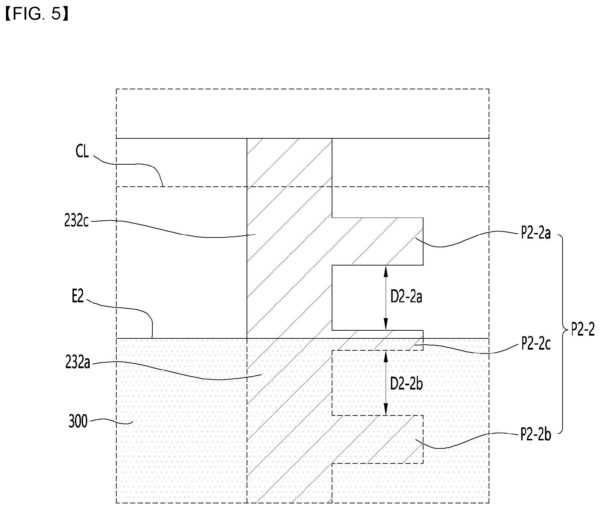

Referring to FIGS. 2 to 5, the first outermost pattern includes a first protruding portion P1-1 and a second protruding portion P1-2.

The first protruding portion P1-1 includes a plurality of protruding portions. In detail, the first protruding portion P1-1 includes a first-first protruding portion P1-1a, a first-second protruding portion P1-1b, and a first-third protruding portion P1-1c.

The first-first protruding portion P1-1a, the first-second protruding portion P1-1b, and the first-third protruding portion P1-1c are each connected to different parts.

The first-first protruding portion P1-1a is connected to the fifth pad part 231b. The first-second protruding portion P1-1b is connected to the third-first wiring part 231a. The first-third protruding portion P1-1c is connected to the third-first wiring part 231a and the fifth pad part 231b.

Therefore, the first-third protruding portion P1-1c is disposed between the first-first protruding portion P1-1a and the first-second protruding portion P1-1b. The first-third protruding portion P1-1c may be disposed at a center between the first-first protruding portion P1-1a and the first-second protruding portion P1-1b. Therefore, a distance D1-1a between the first-first protruding portion P1-1a and the first-third protruding portion P1-1c may be same as or similar to a distance D1-1b between the first-second protruding portion P1-1b and the first-third protruding portion P1-1c.

For example, the distance D1-1a and the distance D1-1b may be 50um to 150um, 70um to 130um, or 90um to 110um.

The second protruding portion P1-2 includes a plurality of protruding portions. In detail, the second protruding portion P1-2 includes a second-first protruding portion P1-2a, a second-second protruding portion P1-2b, and a second-third protruding portion P1-2c.

The second-first protruding portion P1-2a, the second-second protruding portion P1-2b, and the second-third protruding portion P1-2c are each connected to different parts.

The second-first protruding portion P1-2a is connected to the sixth pad part 231c. The second-second protruding portion P1-2b is connected to the third-first wiring part 231a. The second-third protruding portion P1-2c is connected to the third-first wiring part 231a and the sixth pad part 231c.

Therefore, the second-third protruding portion P1-2c is disposed between the second-first protruding portion P1-2a and the second-second protruding portion P1-2b. The second-third protruding portion P1-2c can be disposed at a center between the second-first protruding portion P1-2a and the second-second protruding portion P1-2b. Therefore, a distance D1-2a between the second-first protruding portion P1-2a and the second-third protruding portion P1-2c may be same as or similar to a distance D1-2b between the first-second protruding portion P1-1b and the first-third protruding portion P1-1c.

For example, the distance D1-2a and the distance D1-2b may be 50um to 150um, 70um to 130um, or 90um to 110um.

The second outermost pattern includes the third protruding portion P2-1 and the fourth protruding portion P2-2.

The third protruding portion P2-1 includes a plurality of protruding portions. In detail, the third protruding portion P2-1 includes a third-first protruding portion P2-1a, a third-second protruding portion P2-1b, and a third-third protruding portion P2-1c.

The third-first protruding portion P2-1a, the third-second protruding portion P2-1b, and the third-third protruding portion P2-1c are each connected to different parts.

The third-first protruding portion P2-1a is connected to the seventh pad part 232b. The third-second protruding portion P2-1b is connected to the third-second wiring part 232a. The third-third protruding portion P2-1c is connected to the third-second wiring part 232a and the seventh pad part 232b.

Therefore, the third-third protruding portion P2-1c is disposed between the third-first protruding portion P2-1a and the third-second protruding portion P2-1b. The third-third protruding portion P2-1c can be disposed at the center between the third-first protruding portion P2-1a and the third-second protruding portion P2-1b. Therefore, a distance D2-1a between the third-first protruding portion P2-1a and a third-third protruding portion P2-1c may be the same as or similar to the distance D2-1b between the third-second protruding portion P2-1b and the third-third protruding portion P2-1c.

For example, the distance D2-1a and the distance D2-1b may be 50um to 150um, 70um to 130um, or 90um to 110um.

The third protruding portion P2-1 faces the first protruding portion P1-1 in the second direction. In detail, the first-first protruding portion P1-1a and the third-first protruding portion P2-1a overlap in the second direction 2D, the first-second protruding portion P1-1b and the third-second protruding portion P2-1b overlap in the second direction 2D, and the first-third protruding portion P1-1c and the third-third protruding portion P2-1c overlap in the second direction 2D.

The fourth protruding portion P2-2 includes a plurality of protruding portions. In detail, the fourth protruding portion P2-2 includes a fourth-first protruding portion P2-2a, a fourth-second protruding portion P2-2b, and a fourth-third protruding portion P2-2c.

The fourth-first protruding portion P2-2a, the fourth-second protruding portion P2-2b, and the fourth-third protruding portion P2-2c are each connected to different parts.

The fourth-first protruding portion P2-2a is connected to the eighth pad part 232c. The fourth-second protruding portion P1-2b is connected to the third-second wiring part 232a. The fourth-third protruding portion P2-2c is connected to the third-second wiring part 232a and the eighth pad part 232c.

Therefore, the fourth-third protruding portion P2-2c is disposed between the fourth-first protruding portion P2-2a and the fourth-second protruding portion P2-2b. The fourth-third protruding portion P2-2c may be disposed at a center between the fourth-first protruding portion P2-2a and the fourth-second protruding portion P2-2b. Therefore, a distance D2-2a between the fourth-first protruding portion P2-2a and the fourth-third protruding portion P2-2c may be the same as or similar to a distance D2-2b between the third-second protruding portion P2-1b and the third-third protruding portion P2-1c.

For example, the distance D2-2a and the distance D2-2b may be 50um to 150um, 70um to 130um, or 90um to 110um.

The fourth protruding portion P2-2 faces the second protruding portion P1-2 in the second direction. In detail, the second-first protruding portion P1-2a and the fourth-first protruding portion P2-2a overlap in the second direction 2D, the second-second protruding portion P1-2b and the fourth-second protruding portion P2-2b overlap in the second direction 2D, and the second-third protruding portion P1-2c and the fourth-third protruding portion P2-2c overlap in the second direction 2D.

The end of the protective layer 300 is aligned by the protruding portions.

In detail, the first end E1 is aligned by the first protruding portion P1-1 and the third protruding portion P2-1. The first end E1 is aligned to overlap with the first-third protruding portion P1-1c and the third-third protruding portion P2-1c. When the first end E1 overlaps with both the first-third protruding portion P1-1c and the third-third protruding portion P2-1c, the first end E1 is determined to be aligned.

When the first end E1 does not overlap at least one of the first-third protruding portion P1-1c and the third-third protruding portion P2-1c, the first end E1 is determined to be misaligned.

In this case, an alignment of the first end E1 is adjusted by the first-first protruding portion P1-1a, the first-second protruding portion P1-1b, the third-first protruding portion P2-1a, and the third-second protruding portion P2-1b.

For example, if the first end E1 is located between the first-first protruding portion P1-1a and the first-third protruding portion P1-1c and between the third-first protruding portion P2-1a and the third-third protruding portion P1-1c, it is determined that the first end E1 is tilted downward, and accordingly, a position of the first end E1 is adjusted upward.

Alternatively, if the first end E1 is located between the first-second protruding portion P1-1b and the first-third protruding portion P1-1c and between the third-second protruding portion P2-1b and the third-third protruding portion P2-1c, it is determined that the first end E1 is tilted upward, and accordingly, a position of the first end E1 is adjusted downward.

That is, the alignment of the protective layer can be confirmed by the first-third protruding portion P1-1c and the third-third protruding portion P2-1c, and the alignment position of the protective layer can be adjusted by the first-first protruding portion P1-1a, the first-second protruding portion P1-1b, the third-first protruding portion P2-1a, and the third-second protruding portion P2-1b.

The second end E2 is aligned by the second protruding portion P1-2 and the fourth protruding portion P2-2. The second end E2 is aligned to overlap with the second-third protruding portion P1-2c and the fourth-third protruding portion P2-2c. If the second end E2 overlaps both the second-third protruding portion P1-2c and the fourth-third protruding portion P2-2c, the second end E2 is determined to be aligned.

If the second end E2 does not overlap at least one of the second-third protruding portion P1-2c and the fourth-third protruding portion P2-2c, the second end E2 is determined to be misaligned.

In this case, the alignment of the second end E2 is adjusted by the second-first protruding portion P1-2a, the second-second protruding portion P1-2b, the fourth-first protruding portion P2-2a, and the fourth-second protruding portion P2-2b.

For example, if the second end E2 is located between the second-first protruding portion P1-2a and the second-third protruding portion P1-2c and between the fourth-first protruding portion P2-2a and the fourth-third protruding portion P1-2c, it is determined that the second end E2 is tilted upward, and therefore a position of the second end E2 is adjusted downward.

Alternatively, if the second end E2 is located between the second-second protruding portion P1-2b and the second-third protruding portion P1-2c and between the fourth-second protruding portion P2-2b and the fourth-third protruding portion P2-2c, it is determined that the second end E2 is tilted downward, and therefore the position of the second end E2 is adjusted upward.

That is, the alignment of the protective layer can be confirmed by the second-third protruding portion P1-2c and the fourth-third protruding portion P2-2c, and the alignment position of the protective layer can be adjusted by the second-first protruding portion P1-2a, the second-second protruding portion P1-2b, the fourth-first protruding portion P2-2a, and the fourth-second protruding portion P2-2b.

The flexible circuit board according to the embodiment includes a first outermost pattern and a second outermost pattern.

The first outermost pattern and the second outermost pattern each include a plurality of protruding portions. A first end and a second end of the protective layer are aligned by the protruding portions. It is possible to check whether the first end and the second end are aligned by at least one protruding portion among the protruding portions.

In addition, when the first end and the second end of the protective layer is misaligned, a position of the protective layer can be adjusted by the protruding portions. That is, positions of the first end and the second end can be adjusted by at least one protruding portion among the protruding portions.

Therefore, the flexible circuit board according to the embodiment can align the protective layer without a separate alignment pattern. In addition, when an alignment of the protective layer is misaligned, a position of the protective layer can be easily adjusted through the protruding portion of the protective layer.

Accordingly, since the protective layer is disposed at a desired position, a problem of the protective layer not being disposed on the wiring part or a problem of the protective layer being disposed on the pad part can be solved.

Therefore, the flexible circuit board according to the embodiment can have improved reliability.

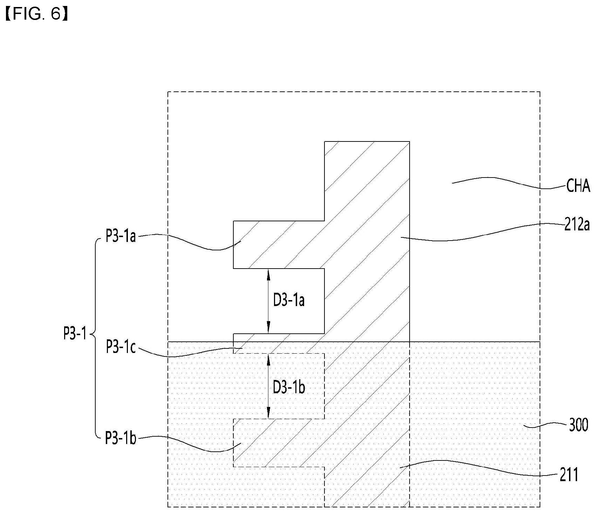

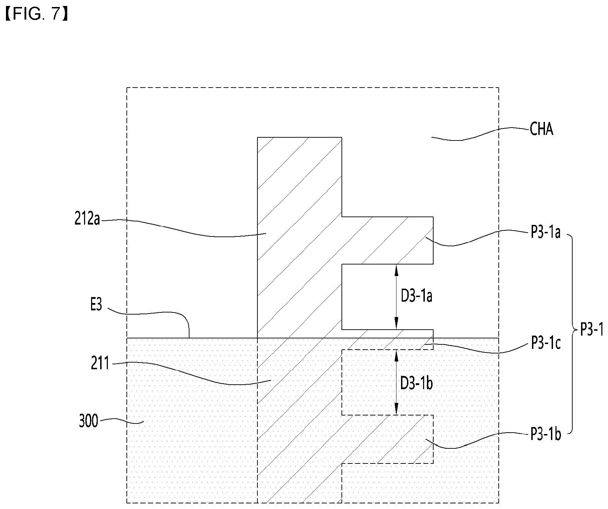

Referring to FIGS. 6 and 7, the first circuit pattern 210 includes an outermost pattern 210a. The outermost pattern 210a is disposed at outermost left and right sides of the first circuit pattern 210.

The outermost pattern 210a of the first circuit pattern 210 includes a fifth protruding portion P3-1.

The fifth protruding portion P3-1 includes a plurality of protruding portions. In detail, the fifth protruding portion P1-1 includes a fifth-first protruding portion P3-1a, a fifth-second protruding portion P3-1b, and a fifth-third protruding portion P3-1c.

The fifth-first protruding portion P3-1a, the fifth-second protruding portion P3-1b, and the fifth-third protruding portion P3-1c are each connected to different parts.

The fifth-first protruding portion P3-1a is connected to the first pad part 212a. The fifth-second protruding portion P3-1b is connected to the first wiring part 211. The fifth-third protruding portion P3-1c is connected to the first wiring part 211 and the fifth-third pad part 212a.

Therefore, the fifth-third protruding portion P3-1c is disposed between the fifth-first protruding portion P3-1a and the fifth-second protruding portion P3-1b. The fifth-third protruding portion P3-1c may be disposed at a center between the fifth-first protruding portion P3-1a and the fifth-second protruding portion P3-1b. Therefore, a distance D3-1a between the fifth-first protruding portion P3-1a and the fifth-third protruding portion P3-1c may be the same as or similar to a distance D3-1b between the fifth-second protruding portion P3-1b and the fifth-third protruding portion P3-1c.

For example, the distance D3-1a and the distance D3-1b may be 50um to 150um, 70um to 130um, or 90um to 110um.

The outermost pattern 220a of the second circuit pattern 220 includes a sixth protruding portion P3-2.

The sixth protruding portion P3-2 includes a plurality of protruding portions. In detail, the sixth protruding portion P3-2 includes a sixth-first protruding portion P3-2a, a sixth-second protruding portion P3-2b, and a sixth-third protruding portion P3-2c.

The sixth-first protruding portion P3-2a, the sixth-second protruding portion P3-2b, and the sixth-third protruding portion P3-2c are each connected to different parts.

The sixth-first protruding portion P3-2a is connected to the third pad part 222a. The sixth-second protruding portion P3-2b is connected to the second wiring part 221. The sixth-third protruding portion P3-2c is connected to the second wiring part 221 and the third pad part 222a.

Therefore, the sixth-third protruding portion P3-2c is disposed between the sixth-first protruding portion P3-2a and the sixth-second protruding portion P3-2b. The sixth-third protruding portion P3-2c can be disposed at a center between the sixth-first protruding portion P3-2a and the sixth-second protruding portion P3-2b. Therefore, a distance D3-2a between the sixth-first protruding portion P3-2a and the sixth-third protruding portion P3-2c may be the same as or similar to a distance D3-2b between the fifth-second protruding portion P3-1b and the fifth-third protruding portion P3-1c.

For example, the distance D3-2a and the distance D3-2b may be 50um to 150um, 70um to 130um, or 90um to 110um.

The protective layer 300 includes a third end E3 adjacent to the first pad part 212a and a fourth end E4 adjacent to the third pad part 222a.

The third end E3 and the fourth end E4 of the protective layer 300 are aligned by the outermost patterns 210a and 220a.

In detail, the third end E1 is aligned by the fifth protruding portion P1-1. The third end E3 is aligned to overlap with the fifth-third protruding portion P1-1c. If the third end E3 overlaps with both the fifth-third protruding portions P3-1c, the third end E3 is determined to be aligned.

If the third end E3 does not overlap with at least one of the fifth-third protruding portions P1-1c, the third end E3 is determined to be misaligned.

In this case, the alignment of the third end E3 is adjusted by the fifth-first protruding portion P1-1a and the fifth-second protruding portion P1-1b.

For example, if the third end E3 is located between the fifth-first protruding portion P3-1a and the fifth-third protruding portion P3-1c, since the first end E1 is tilted upward, the position of the third end E3 is adjusted downward.

Alternatively, if the third end E3 is located between the fifth-second protruding portion P3-1b and the fifth-third protruding portion P1-1c, since the third end E3 is tilted downward, the position of the third end E3 is adjusted upward.

That is, the alignment of the protective layer can be confirmed by the fifth-third protruding portion P1-1c, and the alignment position of the protective layer can be adjusted by the fifth-first protruding portion P1-1a and the fifth-second protruding portion P1-1b.

The fourth end E4 is aligned by the sixth protruding portion P3-2. The fourth end E4 is aligned to overlap with the sixth-third protruding portion P3-2c. If the fourth end E4 overlaps with both the sixth-third protruding portions P3-2c, the fourth end E4 is determined to be aligned.

If the fourth end E4 does not overlap with at least one of the sixth-third protruding portions P1-2c, the fourth end E4 is determined to be misaligned.

In this case, the alignment of the fourth end E4 is adjusted by the sixth-first protruding portion P3-2a and the sixth-second protruding portion P3-2b.

For example, if the fourth end E4 is located between the sixth-first protruding portion P3-2a and the sixth-third protruding portion P3-2c, since the first end E1 is tilted downward, the position of the fourth end E4 is adjusted upward.

Alternatively, if the fourth end E4 is located between the sixth-second protruding portion P3-2b and the sixth-third protruding portion P3-2c, since the fourth end E4 is tilted upward, the position of the fourth end E4 is adjusted downward.

That is, the alignment of the protective layer can be confirmed by the sixth-third protruding portion P3-2c, and the alignment position of the protective layer can be adjusted by the sixth-first protruding portion P1-2a and the sixth-second protruding portion P1-2b.

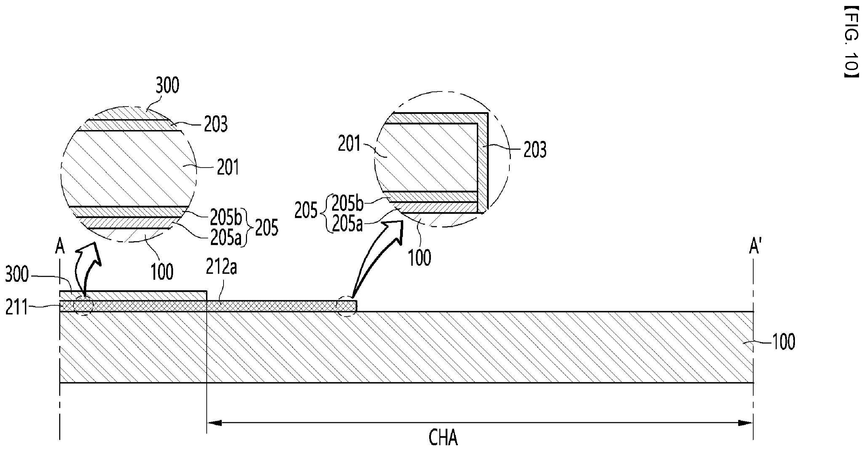

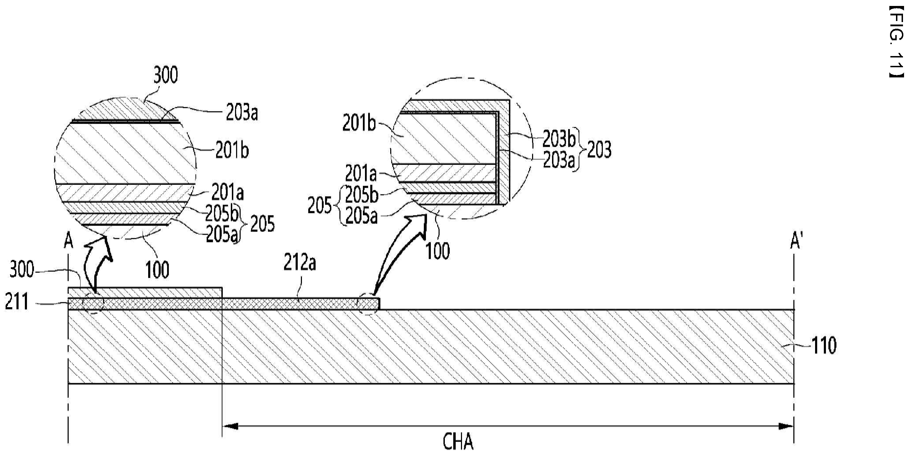

Referring to FIGS. 10 and 11, the circuit pattern is formed in a multilayer structure. FIGS. 10 and 11 are described with reference to the first circuit pattern. The following description applies equally to the second and third circuit patterns.

Referring to FIG. 10, the first circuit pattern is formed in a multilayer structure. In detail, the first wiring part 211, the first pad part 212a, and the second pad part 212b include a buffer layer 205, a metal layer 201, and a bonding layer 203.

The buffer layer 205 may include a multilayer structure. In detail, the buffer layer 205 includes a first buffer layer 205a and a second buffer layer 205b. The first buffer layer 205a is disposed on the substrate 100. The second buffer layer 205b is disposed on the first buffer layer 205a.

The first buffer layer 205a includes a material having good adhesion to the substrate 100. For example, the first buffer layer 205a may include nickel (Ni). In addition, the second buffer layer 205b includes a material having good adhesion to the circuit pattern. For example, the second buffer layer 205b may include chromium (Cr).

The buffer layer 205 may have a thin film thickness in nanometer units. For example, the buffer layer 205 may have a thickness of 20nm or less.

An adhesion between the substrate 100 and the circuit pattern is improved by the buffer layer 205.

The metal layer 201 is disposed on the buffer layer 205. In detail, the metal layer 201 is disposed on the second buffer layer 205b. The metal layer 201 includes a metal material. For example, the metal layer 201 may include copper (Cu).

The metal layer 201 may be formed by electroplating using the buffer layer as a seed layer. That is, the metal layer 201 may be a plating layer.

A thickness of the metal layer 201 may be 10um to 30um.

The bonding layer 203 is disposed on the metal layer 201.

The bonding layer 203 is disposed on side and upper surfaces of the metal layer 201. For example, the bonding layer 203 may be disposed to surround the metal layer 201.

The bonding layer 203 includes a metal. For example, the bonding layer 203 may include tin (Sn). The bonding layer 203 is formed by a plating process. In detail, the bonding layer 203 may be a plating layer.

A thickness of the bonding layer 203 may be 0.3um to 0.7um. A tin content may increase as it extends from the lower surface of the bonding layer 203 toward the upper surface of the bonding layer 203.

That is, the bonding layer 203 is in contact with the metal layer 201. Therefore, a tin content increases as it extends from the lower surface of the bonding layer 203 toward the upper surface of the bonding layer 203. In addition, a copper content decreases as it extends from the lower surface of the bonding layer 203 toward the upper surface of the bonding layer 203.

Accordingly, pure tin may remain in a thickness range of 0.1um to 0.3um from the upper surface of the bonding layer 203.

The pad part may be easily bonded to the terminal of the chip, the circuit board, and the display panel by the bonding layer 203. For example, when heat and pressure are applied to the pad part, the upper surface of the bonding layer melts. Pure tin remains on the upper surface of the bonding layer. Therefore, the pad part is easily bonded to the terminals of the chip, the circuit board, and the display panel.

Referring to FIG. 11, the metal layer 201 layer may include a first metal layer 201a and a second metal layer 201b. The first metal layer 201a is disposed on the buffer layer 205. The second metal layer 201b is disposed on the first metal layer 201a. The second metal layer 201b may be formed by electroplating using the first metal layer 201a as a seed layer. That is, the second metal layer 201b may be a plating layer.

A thickness of the first metal layer 201a may be smaller than a thickness of the second metal layer 201b.

For example, the thickness of the first metal layer 201a may be 0.7um to 2um, and the thickness of the second metal layer 201b may be 6um to 25um.

The first metal layer 201a and the second metal layer 201b may include a same metal material. For example, the first metal layer 201a and the second metal layer 201b may include copper (Cu).

The bonding layer 203 may include a first bonding layer 203a and a second bonding layer 203b.

The first bonding layer 203a is disposed on the metal layer 201. In detail, the first bonding layer 203a is disposed on the second wiring part 221, the third pad part 222a, and the fourth pad part 222b.

The second bonding layer 203b is disposed on the first bonding layer 203a. In detail, the second bonding layer 203b is disposed on the third pad part 222a and the fourth pad part 222b.

Therefore, the second wiring part 221 includes the buffer layer 205, the metal layer 201, and the first bonding layer 203a. In addition, the third pad part 222a and the fourth pad part 222b include the buffer layer 205, the metal layer 201, the first bonding layer 203a, and the second bonding layer 203b.

Therefore, a layer structure of the second wiring part 221 is different from layer structures of the first pad part 212a and the second pad part 212b.

The first bonding layer 203a and the second bonding layer 203b include a metal. In detail, the first bonding layer 203a and the second bonding layer 203b may include tin (Sn).

The first bonding layer 203a and the second bonding layer 203b are disposed with different thicknesses. In detail, a thickness of the second bonding layer 203b is greater than a thickness of the first bonding layer 203a.

For example, the first bonding layer 203a has a thickness of 0.02um to 0.06um. In addition, the second bonding layer 203b has a thickness of 0.2um to 0.6um.

Therefore, the thickness of the first wiring part 211 is reduced. The flexible circuit board includes a bending region BA that is bent in one region. A wiring part is disposed on the bending region BA. Therefore, the thickness of the bonding layer on the wiring part is formed small. Accordingly, when the flexible circuit board is bent, cracks can be prevented from being formed in the first wiring part 211.

The thickness of the above circuit pattern may exceed 8 µm and be less than or equal to 25 µm. In detail, the thickness of the circuit pattern may be 9um to 20um. In detail, the thickness of the circuit pattern may be 10um to 15um.

If the thickness of the circuit pattern is less than 8um, the resistance of the circuit pattern may increase. In addition, if a high current flows through the display panel, the circuit pattern may be damaged. If the thickness of the circuit pattern exceeds 25um, it becomes difficult to implement a fine pattern.

Hereinafter, a flexible circuit board, a COF module, and an electronic device including the same according to an embodiment will be described with reference to the drawings.

Hereinafter, a flexible circuit board according to a second embodiment will be described. In a description of the flexible circuit board of the second embodiment, descriptions substantially the same as those of the first embodiment will be omitted. The flexible circuit board of the first embodiment is a single-sided flexible circuit board having a structure in which a circuit pattern is disposed on only one side of the substrate 100. In contrast, the flexible circuit board of the second embodiment may be a double-sided flexible circuit board having a structure in which a circuit pattern is disposed on both sides of the substrate 100.

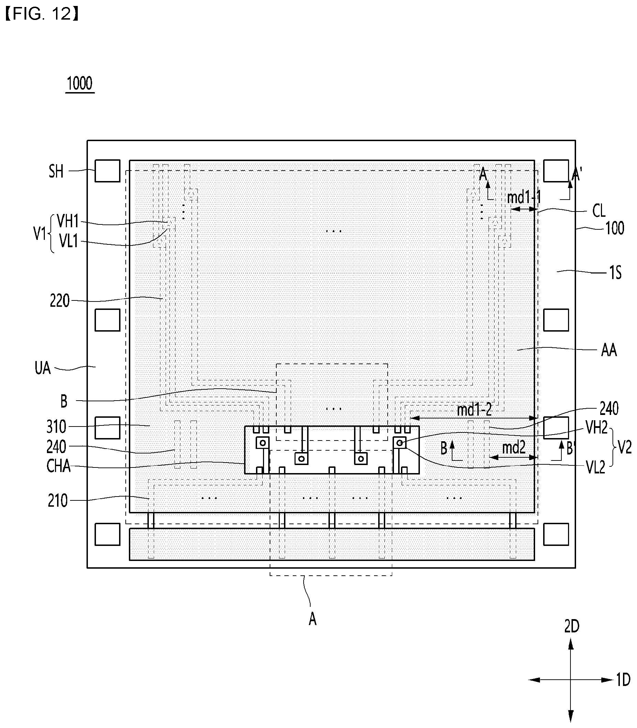

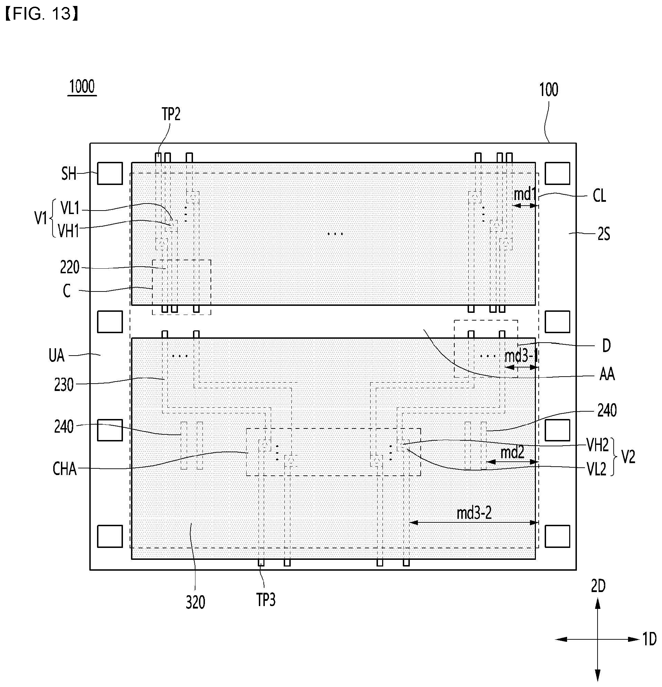

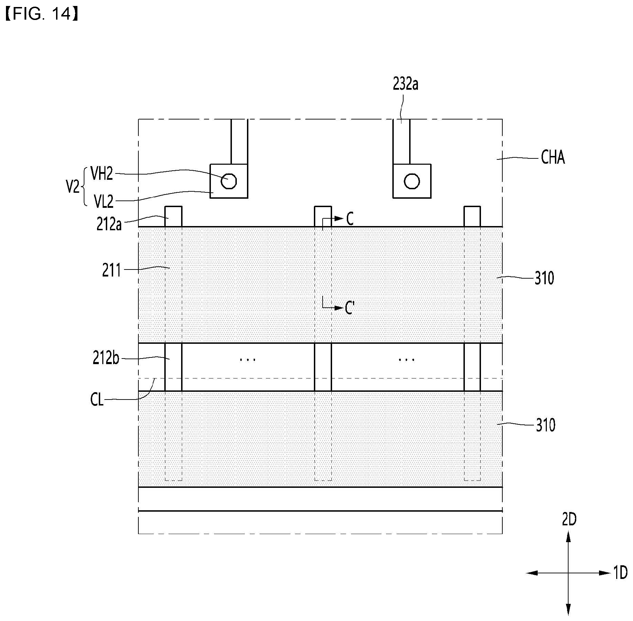

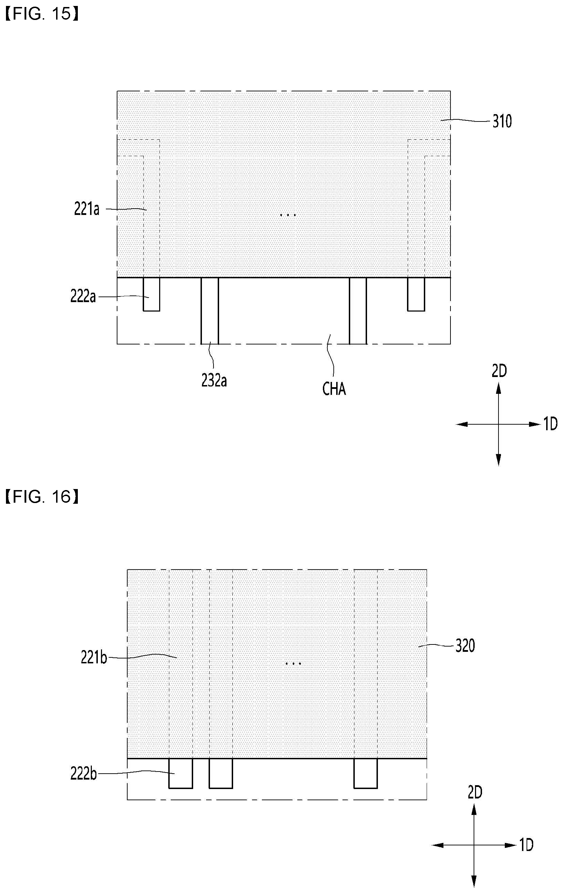

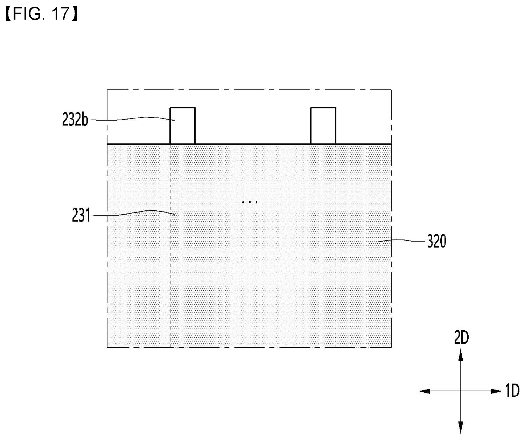

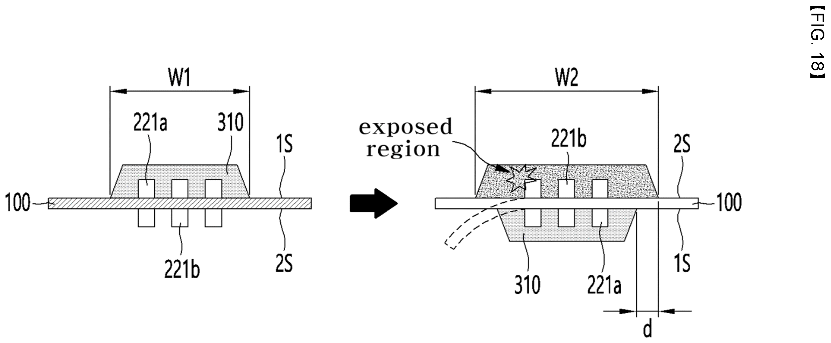

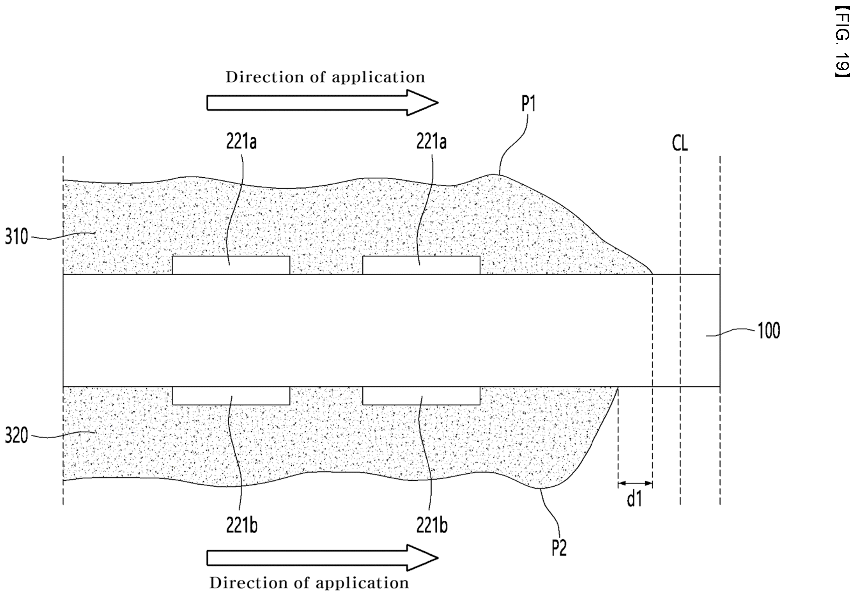

FIG. 12 is a top view of a flexible circuit board according to a second embodiment, FIG. 13 is a bottom view of a flexible circuit board according to a second embodiment, FIG. 14 is a view showing an enlarged view of region A of FIG. 12, FIG. 15 is a view showing an enlarged view of region B of FIG. 12, FIG. 16 is a view showing an enlarged view of region C of FIG. 13, FIG. 17 is a view showing an enlarged view of region D of FIG. 13, FIG. 18 is a view for explaining a problem due to a difference in an area of a protective layer, FIGS. 19 to 21 are cross-sectional views taken along region A-A' of FIG. 12, and FIGS. 22 and 23 are cross-sectional views taken along region B-B' of FIG. 12.

Referring to FIGS. 12 to 17, a flexible circuit board 1000 according to an embodiment includes a substrate 100, a circuit pattern, and a protective layer.

The substrate 100 includes a first surface 1S and a second surface 2S opposite to the first surface 1S. A circuit pattern and a protective layer are disposed on the first surface 1S and the second surface 2S.

The substrate 100 includes a cutting line CL. The substrate 100 may include an effective region AA and an ineffective region UA. The substrate 100 includes a chip mounting region CHA.

The circuit pattern may include a first circuit pattern 210, a second circuit pattern 220, and a third circuit pattern 230. The protective layer may include a first protective layer 310 and a second protective layer 320.

Referring to FIG. 12 and FIG. 14, the first circuit pattern 210 is disposed on the first surface 1S. The first circuit pattern 210 includes a first wiring part 211, a first pad part 212a, and a second pad part 212b. The first wiring part 211, the first pad part 212a, and the second pad part 212b may include a same material. The first wiring part 211, the first pad part 212a, and the second pad part 212b may be formed integrally.

The first pad part 212a is disposed inside the chip mounting region CHA. Accordingly, the first pad part 212a is connected to a terminal of the chip. Accordingly, the first circuit pattern 210 and the chip are connected.

The second pad part 212b is disposed outside the chip mounting region CHA. The second pad part 212b is connected to a terminal of an external circuit board. Accordingly, the first circuit pattern 210 and the circuit board are connected.

The second pad part 212b may be a first test pad part. In detail, the first circuit board may be tested before connecting the circuit board and the second pad part 212b. For example, the second pad part 212b may be used to check whether the first circuit pattern is open or shorted.

The first wiring part 211 is disposed between the first pad part 212a and the second pad part 212b. The first wiring part 211 connects the first pad part 212a and the second pad part 212b. Accordingly, the chip and the circuit board are connected. Accordingly, a signal generated from the chip is transmitted to the circuit board.

A first protective layer 310 is disposed on the first circuit pattern 210. The first protective layer 310 is disposed on the first wiring part 211. The first protective layer 310 is not disposed on the first pad part 212a and the second pad part 212b.

Referring to FIGS. 12, 13, 15, and 16, the second circuit pattern 220 is disposed on the first surface 1S and the second surface 2S. The second circuit pattern 220 includes the second wiring part 221a and 221b, the third pad part 222a, the fourth pad part 222b, and the first via V1. The second wiring part 221a and 221b, the third pad part 222a, and the fourth pad part 222b may include a same material. In addition, the second wiring part 221a and 221b, the third pad part 222a, and the fourth pad part 222b may be formed integrally.

The first protective layer 310 and the second protective layer 320 are disposed on the second wiring part 221a and 221b. The first protective layer 310 and the second protective layer 320 are not disposed on the third pad part 222a and the fourth pad part 222b.

The third pad part 222a is disposed on the first surface 1S. The third pad part 222a is disposed inside the chip mounting region CHA. Accordingly, the third pad part 222a is connected to the terminal of the chip. Accordingly, the second circuit pattern 220 and the chip are connected.

The fourth pad part 222b is disposed on the second surface 2S. The fourth pad part 222b is connected to a terminal of an external display panel. Accordingly, the second circuit pattern 220 and the display panel are connected.

he second wiring part includes a second-first wiring part 221a and a second-second wiring part 221b. The second-first wiring part 221a is disposed on the first surface 1S. The second-second wiring part 221b is disposed on the second surface 2S. The second wiring part 221a and 221b connects the third pad part 222a and the fourth pad part 222b. In detail, the second-first wiring part 221a is connected to the third pad part 222a. The second-second wiring part 221b is connected to the fourth pad part 222b.

Accordingly, the chip and the display panel are connected. Accordingly, a signal generated from the chip is transmitted to the display panel.

A first protective layer 310 and a second protective layer 320 are disposed on the second circuit pattern 220. In detail, the first protective layer 310 is disposed on the second circuit pattern 220 on the first surface 1S. The second protective layer 320 is disposed on the second circuit pattern 220 on the second surface 2S. The first protective layer 310 and the second protective layer 320 are not disposed on the third pad part 222a and the fourth pad part 222b.

The second-first wiring part 221a and the second-second wiring part 221b are connected. The second-first wiring part 221a and the second-second wiring part 221b are connected through the first via V1. The first via V1 penetrates the first surface 1S and the second surface 2S. Accordingly, the first via V1 is disposed on the first surface 1S and the second surface 2S. The first via V1 on the first surface 1S and the first via V1 on the second surface 2S are disposed at corresponding positions.

The first via V1 includes a first via land VL1 and a first via hole VH1. The first via hole VH1 is formed inside the first via land VL1. The first via land VL1 includes the same material as the second wiring part 221a and 221b. A conductive material is disposed in the first via hole VH1. Accordingly, the second-first wiring part 221a and the second-second wiring part 221b are electrically connected.

The second circuit pattern 220 may include a second test pad part TP2. The second test pad part TP2 may be disposed on the second surface 2S. The second test pad part TP2 may be disposed in an ineffective region UA. The second protective layer 320 is not disposed on the second test pad part TP2. The second test pad part TP2 can be connected to the second-second wiring part 221b. In detail, the second test pad part TP2 and the second-second wiring part 221b can be formed integrally.

The second circuit pattern 220 can be tested before connecting the display panel and the fourth pad part 222b. For example, the second test pad part TP2 can be used to check whether the second circuit pattern is open or shorted.

Referring to FIGS. 12, 13, 14, and 17, the third circuit pattern 230 is disposed on the first surface 1S and the second surface 2S. The third circuit pattern 230 includes the third wiring part 231, the fifth pad part 232a, the sixth pad part 232b, and the second via V2. The third wiring part 231, the fifth pad part 232a, and the sixth pad part 232b may include a same material. In addition, the third wiring part 231, the fifth pad part 232a, and the sixth pad part 232b may be formed integrally.

The fifth pad part 232a is disposed on the first surface 1S. The fifth pad part 232a is disposed inside the chip mounting region CHA. Accordingly, the fifth pad part 232a is connected to the terminal of the chip. Accordingly, the third circuit pattern 230 and the chip are connected.

The sixth pad part 232b is disposed on the second surface 2S. The sixth pad part 232b is connected to the terminal of the display panel. Accordingly, the third circuit pattern 230 and the display panel are connected.

The third wiring part 231 connects the fifth pad part 232a and the sixth pad part 232b. Accordingly, the chip and the display panel are connected. Accordingly, a signal generated from the chip is transmitted to the display panel.

A second protective layer 320 is disposed on the third circuit pattern 230. The second protective layer 320 is disposed on the third circuit pattern 230 on the second surface 2S. The second protective layer 320 is not disposed on the sixth pad part 232b.

The fifth pad part 232a and the third wiring part 231 are connected. In detail, the fifth pad part 232a and the third wiring part 231 are connected through the second via V2. The second via V2 penetrates the first surface 1S and the second surface 2S. Accordingly, the second via V2 is disposed on the first surface 1S and the second surface 2S. The second via V2 on the first surface 1S and the second via V2 on the second surface 2S are disposed at positions corresponding to each other.

The second via V2 includes a second via land VL2 and a second via hole VH2. The second via land VL2 includes the same material as the third wiring part 231. The second via hole VH2 is formed inside the second via land VL2. A conductive material is disposed in the second via hole VH2. Accordingly, the fifth pad part 232a and the third wiring part 231 are electrically connected.

The third circuit pattern 230 may include a third test pad part TP3. The third test pad part TP3 can be disposed on the second surface 2S. The third test pad part TP3 can be disposed on the ineffective region UA. In addition, the second protective layer 320 is not disposed on the third test pad part TP3. The third test pad part TP3 can be connected to the third wiring part 231. In detail, the third test pad part TP3 can be formed integrally with the third wiring part 231.

The third circuit pattern 230 can be tested before connecting the display panel and the sixth pad part 232b. For example, the third test pad part TP3 can be used to check whether the third circuit pattern is open or shorted.

Although not shown in the drawing, the circuit pattern can further include an additional circuit pattern. For example, the circuit pattern can further include a power supply pattern. The power supply pattern can be connected to a terminal of the circuit board and a terminal of the display panel. Accordingly, power can be transmitted to the circuit board and the display panel.

The flexible circuit board 1000 may further include a dummy pattern 240. The dummy pattern 240 may be disposed on the effective region AA and the ineffective region UA. The dummy pattern on the ineffective region UA increases the strength of the substrate 100. The dummy pattern 240 on the effective region AA improves the uniformity of the circuit pattern. In detail, the width, thickness, and spacing of the circuit pattern may be made uniform by the dummy pattern 240.

The dummy pattern 240 is not a pattern on which a signal moves. The dummy pattern 240 is not connected to the terminal of the circuit board and the terminal of the display panel.

The protective layer includes a first protective layer 310 and a second protective layer 320. The first protective layer is disposed on the first surface 1S. The second protective layer 320 is disposed on the second surface 2S.

The first protective layer 310 is disposed on the circuit pattern on the first surface 1S. In detail, the first protective layer 310 is disposed on the first circuit pattern 210 and the second circuit pattern 220 on the first surface 1S. The second protective layer 320 is disposed on the second circuit pattern 220 and the third circuit pattern 230 on the second surface 2S.

The first protective layer 310 and the second protective layer 320 are disposed sequentially. For example, after one protective layer is disposed, it can be flipped over and another protective layer can be disposed on another surface.

The first protective layer 310 and the second protective layer 320 can be disposed in different areas. Therefore, the substrate can be bent when forming the protective layer. Accordingly, the circuit pattern can be exposed to an outside of the protective layer.

The protective layers 310 and 320 are applied in the first direction 1D. The pad parts are disposed in the second direction 2D of the flexible circuit board. Accordingly, if the protective layer 310 and 320 is applied in the second direction, a defect in the pad part may occur due to a process error. A wiring part or a dummy pattern is disposed in the first direction 1D of the flexible circuit board. Accordingly, the process freedom is secured in the first direction 1D of the flexible circuit board. Therefore, the protective layer 310 and 320 is applied in the first direction.

Referring to FIG. 18, a first protective layer 310 and a second protective layer 320 are disposed on the substrate 100. The first protective layer 310 is disposed on the first surface 1S. The second protective layer 320 is disposed on the second surface 2S.

The protective layers 310 and 320 are disposed sequentially. For example, after forming a first protective layer 310 on a first surface 1S, a second protective layer 320 is formed on a second surface 2S.

The first protective layer 310 is formed with a first width W1. The first width W1 is a width in a first direction 1D. The second protective layer 320 is formed with a second width W2. The second width W2 is a width in a second direction 2D.

If the second width W2 is larger than the first width W1, the substrate 100 may be warped. In detail, if the second width W2 is larger than the first width W1, the second protective layer 320 is also disposed on the first surface 1S where the first protective layer 310 is not disposed. If a difference (d) between ends of the first protective layer 310 and the second protective layer 320 increases, the substrate 100 is warped by a pressure generated when forming the second protective layer 320. Accordingly, a part of the outermost circuit pattern disposed at a point where the application of the second protective layer 320 ends may be exposed to an outside of the second protective layer 320. Therefore, corrosion of the circuit pattern may occur, which may reduce the reliability of the flexible circuit board.

Therefore, the embodiment controls sizes of the first protective layer 310 and the second protective layer 320. Accordingly, the reliability of the flexible circuit board is secured.

Referring to FIGS. 12 and 13, the flexible circuit board includes an outermost pattern. The outermost pattern is a pattern having a minimum separation distance from the cutting line CL. In detail, the outermost pattern is a pattern including a region having a minimum separation distance from the cutting line CL.

The outermost pattern may be a circuit pattern or a dummy pattern. For example, the outermost pattern may be a circuit pattern.

Referring to FIG. 12, the outermost pattern on the first surface 1S may be an outermost pattern of the second circuit pattern.

The dummy pattern 240 is disposed further outside the outermost pattern of the second circuit pattern. However, a minimum distance between the outermost pattern of the second circuit pattern and the cutting line CL is smaller than a minimum distance between the dummy pattern 240 and the cutting line CL.

In detail, a distance between the outermost pattern of the second circuit pattern and the cutting line CL may vary depending on the location. That is, a distance between the outermost pattern of the second circuit pattern and the cutting line CL may have a plurality of distances. For example, the plurality of distances between the outermost pattern of the second circuit pattern and the cutting line CL may include a first-first distance (md1-1) and a first-second distance (md1-2). The first-first distance (md1-1) is smaller than the first-second distance (md1-2). Therefore, a minimum distance between the outermost pattern of the second circuit pattern and the cutting line CL becomes the first-first distance (md1-1).

The first-first distance (md1-1) is smaller than a second distance (md2) between the dummy pattern 240 and the cutting line CL. In addition, the first-second distance (md1-2) may be larger than, smaller than, or equal to the second distance (md2).

Therefore, in a case of FIG. 12, the outermost pattern on the first surface 1S may be an outermost pattern of the second circuit pattern.

Referring to FIG.. 13, the outermost pattern on the second surface 2S may be the outermost pattern of the second circuit pattern.

The outermost pattern of the third circuit pattern is arranged on the outside, corresponding to the outermost pattern of the second circuit pattern. However, a minimum distance between the outermost pattern of the second circuit pattern and the cutting line CL is smaller than a minimum distance between the outermost pattern of the third circuit pattern and the cutting line CL.

In detail, a distance between the outermost pattern of the second and third circuit patterns and the cutting line CL may vary depending on the location. That is, the distance between the outermost pattern of the second and third circuit patterns and the cutting line CL may have a plurality of distances. For example, the plurality of distances between the outermost pattern of the second circuit pattern and the cutting line CL may include a first distance (md1). The plurality of distances between the outermost pattern of the third circuit pattern and the cutting line CL may include a third-first distance (md3-1) and a third-second distance (md3-2). The third-first distance (md3-1) is smaller than the third-second distance (md3-2). Therefore, a minimum distance between the outermost pattern of the third circuit pattern and the cutting line CL becomes the third-first distance (md1-1).

The first distance (md1) is smaller than the third-first distance (md3-1). In addition, the first distance (md1) is smaller than the second distance (md2) between the dummy pattern 240 and the cutting line CL.

Therefore, in a case of FIG. 13, the outermost pattern on the second surface 2S may be an outermost pattern of the second circuit pattern.

However, the embodiment is not limited thereto. Another circuit pattern or another dummy pattern may be disposed on a region having a minimum distance (md1, md1-1) between the outermost pattern of the second circuit pattern and the cutting line CL. In this case, the outermost pattern of the flexible circuit board may be another circuit pattern or another dummy pattern.

For example, an outermost pattern on the first surface 1S may be the outermost pattern of at least one circuit pattern among the first circuit pattern and the second circuit pattern, and an outermost pattern on the second surface 2S may be the outermost pattern of at least one circuit pattern among the second circuit pattern and the third circuit pattern.

Alternatively, the outermost pattern on the first surface 1S may be the outermost pattern of at least one circuit pattern among the first circuit pattern and the second circuit pattern, and the outermost pattern on the second surface 2S may be a dummy pattern.

Alternatively, the outermost pattern on the first surface 1S may be a dummy pattern, and the outermost pattern on the second surface 2S may be an outermost pattern of at least one of the second circuit pattern and the third circuit pattern.

Hereinafter, for convenience of explanation, it will be described as an example that the outermost pattern on the first surface 1S is an outermost pattern of the second circuit pattern, and the outermost pattern on the second surface 2S is an outermost pattern of the second circuit pattern or an outermost pattern of a dummy pattern.

Referring to FIGS. 19 to 21, the first protective layer 310 and the second protective layer 320 are applied in the first direction.

The first protective layer 310 on a region where the outermost pattern on the first surface has a first-first distance and the second protective layer 320 on a region where the outermost pattern on the second surface has a first distance are disposed with different widths. In detail, an end of the first protective layer 310 formed by applying the first protective layer 310 and an end of the second protective layer 320 formed by applying the second protective layer 320 are misaligned in a thickness direction of the substrate 100.

Therefore, a distance between the first protective layer 310 and the cutting line CL and a distance between the second protective layer 320 and the cutting line CL are different. In detail, a distance between the first protective layer 310 and the cutting line CL and a distance between the second protective layer 320 and the cutting line CL are different.

Referring to FIG. 19, the second-first wiring part 221a, which is the outermost pattern on the first surface 1S, and the second-second wiring part 221b, which is the outermost pattern on the second surface 2S, overlap in a thickness direction of the substrate 100.

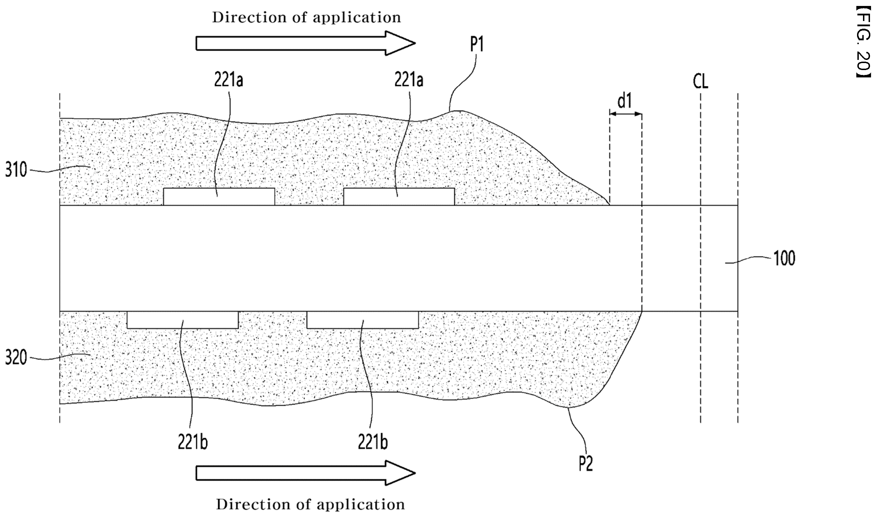

Alternatively, referring to FIG. 20, the second-first wiring part 221a, which is the outermost pattern on the first surface 1S, and the second-second wiring part 221b, which is the outermost pattern on the second surface 2S, partially overlap in the thickness direction of the substrate 100.

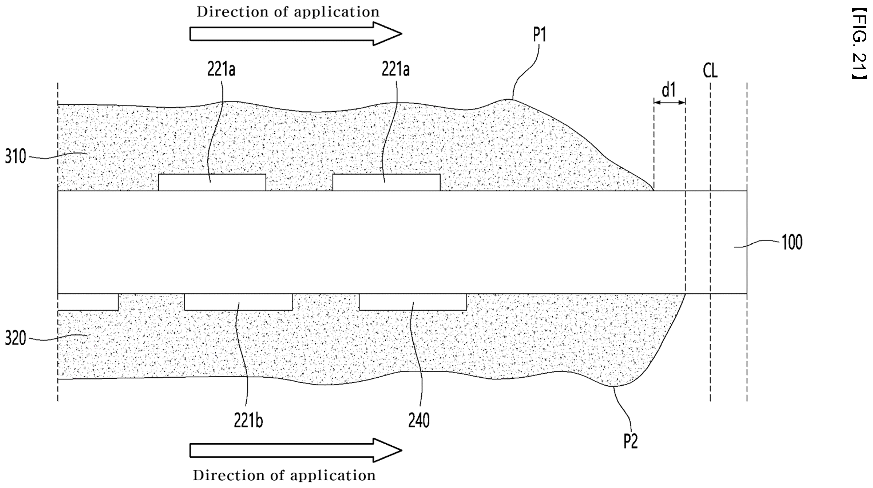

Alternatively, referring to FIG. 21, the second-first wiring part 221a, which is the outermost pattern on the first surface 1S, and the second-second wiring part 221b, which is the outermost pattern on the second surface 2S, are partially misaligned in the thickness direction of the substrate 100. A dummy pattern 240 is disposed between the second-second wiring part 221b, which is the outermost pattern on the second surface 2S, and the cutting line CL. The second-first wiring part 221a, which is the outermost pattern on the first surface 1S, and the dummy pattern 240 overlap completely or partially in the thickness direction of the substrate 100. Therefore, a difference between the ends of the first protective layer 310 and the second protective layer 320 can be reduced by the dummy pattern.

Therefore, the first protective layer 310 is disposed while covering the second-first wiring part 221a, which is the outermost pattern on the first surface 1S. In addition, the second protective layer 320 is disposed while covering the second-second wiring part 221b, which is the outermost pattern on the second surface 2S, or the dummy pattern 240.

However, due to an error during a process, ends of the first protective layer 310 and the ends of the second protective layer 320 may be misaligned in the thickness direction of the substrate 100. The first protective layer 310 and the second protective layer each have a first peak P1 and a second peak P2. The first peak P1 and the second peak P2 may be regions of the protective layers having a largest thickness. Alternatively, the first peak P1 and the second peak P2 may be regions where the thickness of the protective layers begins to decrease.

Since an end of the first protective layer 310 and an end of the second protective layer 320 are misaligned in the thickness direction of the substrate 100, the first peak P1 and the second peak P2 are also misaligned in the thickness direction of the substrate 100.

One end of the first protective layer 310 and one end of the second protective layer 320 may be misaligned by a first distance (d1).

The first distance (d1) has a set range. The first distance may be less than or equal to a width of a wiring part of the circuit pattern. The first distance may be less than or equal to a width of a pad part of the circuit pattern. The first distance is smaller than a spacing of the wiring parts of the circuit pattern. The first distance may be less than or equal to a spacing of the pad parts of the circuit pattern. The first distance may be less than or equal to a pitch of the wiring parts of the circuit pattern. The first distance may be less than or equal to a pitch of the pad parts of the circuit pattern.

For example, the first distance (d1) has a set size. In detail, the first distance (d1) may be less than or equal to 60 µm, less than or equal to 30 µm, or less than or equal to 15 µm. If the first distance (d1) exceeds 60 µm, an end of the substrate may be bent due to an area difference between the first protective layer 310 and the second protective layer 320. Therefore, the protective layer may not completely cover the outermost circuit pattern disposed on the first surface or the second surface. Accordingly, the outermost circuit pattern disposed on the first surface or the second surface may be exposed to an outside of the protective layer. As a result, corrosion of the circuit pattern may occur, thereby deteriorating the reliability of the flexible circuit board.

A distance difference between the protective layers disposed on the outermost pattern and a distance difference between the protective layers disposed on patterns other than the outermost pattern may be different. In detail, a distance between ends of the protective layers on a first region may be different from a distance between ends of the protective layers on a second region.

Referring to FIG. 12, FIG. 22, and FIG. 23, a dummy pattern 240 may be disposed on the first surface and the second surface. The dummy pattern 240 may not be an outermost pattern on the first surface and the second surface.

The dummy pattern 240 includes a first dummy pattern 241 and a second dummy pattern 242. The first dummy pattern 241 is disposed on the first surface 1S. The second dummy pattern 242 is disposed on the second surface 2S.

The first dummy pattern 241 may include a plurality of dummy patterns spaced apart from each other. In addition, the first dummy pattern 241 includes an outermost first dummy pattern 241a that is closest to the cutting line CL among the dummy patterns.

The second dummy pattern 242 may include a plurality of dummy patterns spaced apart from each other. In addition, the second dummy pattern 242 includes an outermost second dummy pattern 242a that is closest to the cutting line CL among the dummy patterns.

However, the outermost first dummy pattern 241a and the outermost second dummy pattern 241b are not outermost patterns of the flexible circuit board.

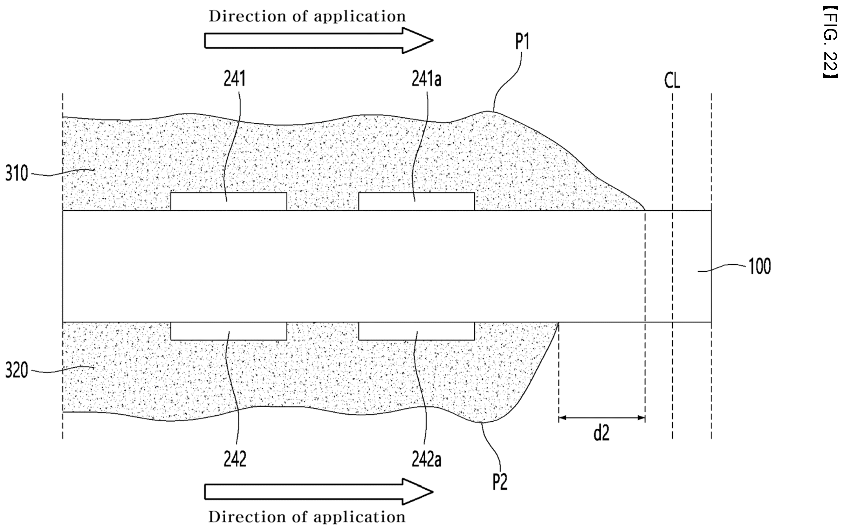

Referring to FIG. 22, the outermost first dummy pattern 241a on the first surface 1S and the outermost second dummy pattern 242a on the second surface 2S may be completely or partially overlapped in the thickness direction of the substrate 100.

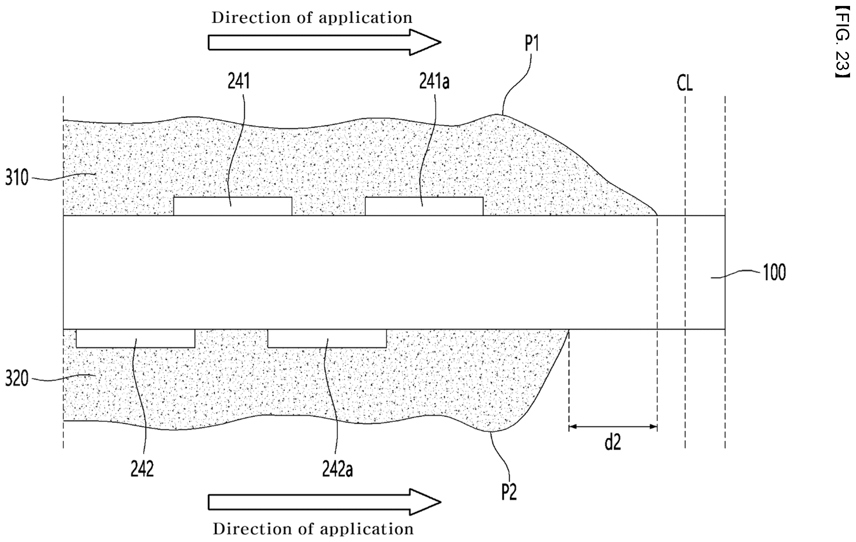

Alternatively, referring to FIG. 23, the outermost first dummy pattern 241a on the first surface 1S and the outermost second dummy pattern 242a on the second surface 2S may be misaligned in the thickness direction of the substrate 100.

Even if the outermost first dummy pattern 241a and the outermost second dummy pattern 242a are misaligned, the outermost dummy patterns may be completely covered by the protective layer 310 and 320. That is, since the outermost first dummy pattern 241a and the outermost second dummy pattern 242a are not the outermost patterns of the flexible circuit board, they are disposed with a sufficient distance from the ends of the protective layers. Accordingly, the substrate 100 does not bend in a region where the outermost first dummy pattern 241a and the outermost second dummy pattern 242a are disposed. Therefore, even if the outermost first dummy pattern 241a and the outermost second dummy pattern 242a are misaligned, the outermost dummy patterns are not exposed to the outside of the protective layer 310 and 320.

The first protective layer 310 is disposed while covering the outermost first dummy pattern 241a on the first surface 1S. In addition, the second protective layer 320 is disposed while covering the outermost second dummy pattern 242a on the second surface 2S.

However, due to an error during the process, the end of the first protective layer 310 and the end of the second protective layer 320 may be misaligned in the thickness direction of the substrate 100. In detail, the end of the first protective layer 310 and the end of the second protective layer 320 may be misaligned by a second distance (d2).

The first distance (d1) and the second distance (d2) may be different. The first distance (d1) is smaller than the second distance (d2). For example, the second distance (d2) may be more than 60um, 70um or more, or 80um or more.

As described above, the outermost first dummy pattern 241a and the outermost second dummy pattern 242a are not the outermost patterns of the flexible circuit board. Therefore, the outermost first dummy pattern 241a and the outermost second dummy pattern 242a are not disposed in a region where the substrate is warped due to an increase in the second distance (d2). Therefore, even if the second distance (d2) increases, the outermost first dummy pattern 241a and the outermost second dummy pattern 242a are not exposed to the outside of the protective layers.

In addition, since the degree of freedom of tolerance at the ends of the protective layers in regions other than the outermost patterns is increased, a process efficiency can be improved.

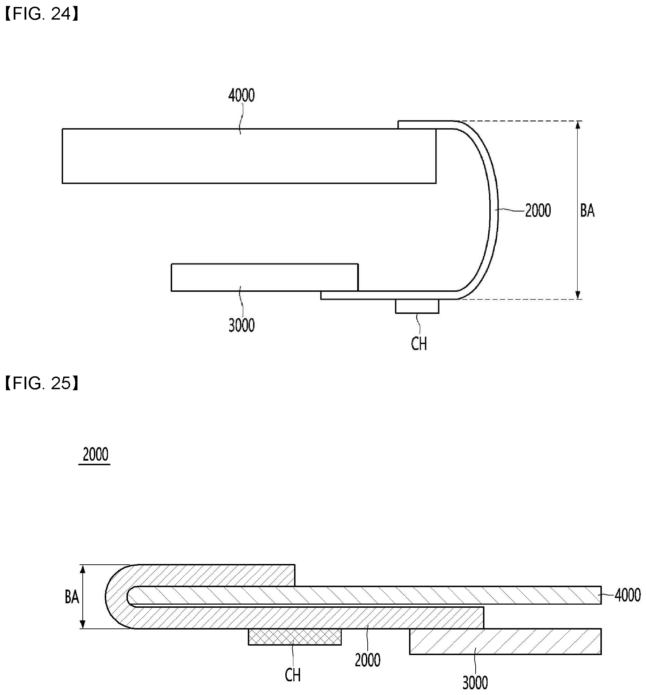

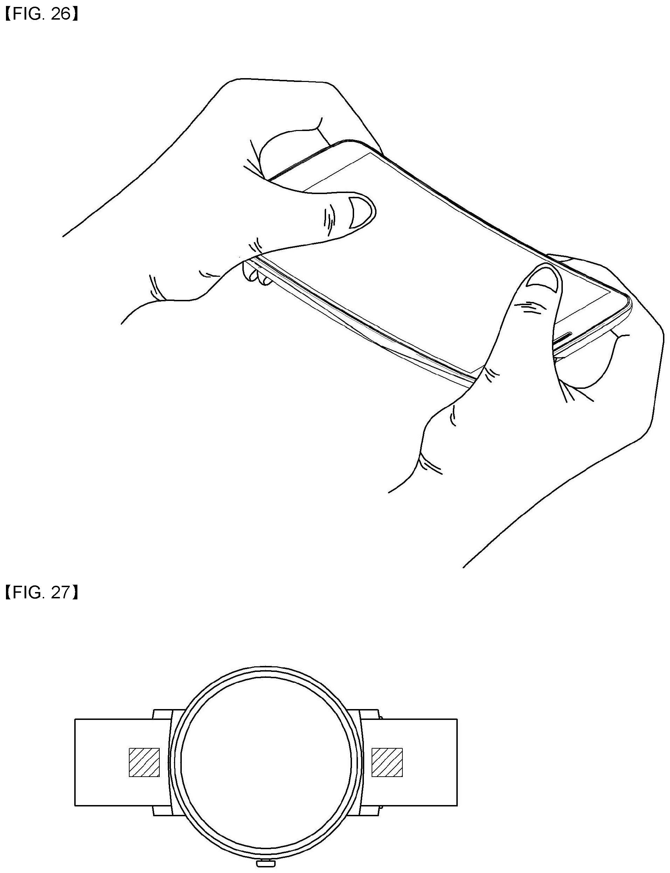

FIG. 24 is a view for explaining a connection between a COF module and other members according to a first embodiment, FIG. 25 is a view for explaining a connection between a COF module and other members according to a second embodiment, and FIGS. 26 to 28 are views for an electronic device including a flexible circuit board according to an embodiment.

Referring to FIG. 24, one end of the COF module 2000 is connected to the display panel 4000, and another end is connected to the circuit board 3000. For example, the display panel 4000 and the circuit board 3000 are disposed on one surface of the COF module 2000. However, the embodiment is not limited thereto. The display panel 4000 and the circuit board 3000 may be disposed on another surface of the COF module 2000. In this case, the COF module 2000 may have circuit patterns disposed on each of both surfaces. For example, the COF module 2000 may include a first circuit pattern and a second circuit pattern disposed on a first surface, and a second circuit pattern and a third circuit pattern disposed on the second surface. The second circuit patterns may be connected to each other through vias.

Since the COF module 2000 includes a flexible substrate, it has a rigid shape and a bent shape between the display panel 3000 and the circuit board 4000. That is, the COF module 2000 may include a bending region BA.

The COF module 2000 connects the display panel 4000 and the circuit board 3000 that are disposed opposite each other in a bent shape. Therefore, the thickness of the electronic device is reduced. In addition, the design freedom of the electronic device is improved. In addition, a wiring of the COF module 2000 is not broken even in a bent shape. Accordingly, the reliability of the electronic device is improved.

Referring to FIG. 25, a chip CH is mounted on the flexible circuit board. Then, it is cut along the cutting line CL. By this, the COF module is manufactured.

The COF module 2000 can transmit an electrical signal by connecting a display panel 4000 and a circuit board 3000. One end of the COF module 2000 is connected to the display panel 4000. Another end of the COF module 2000 is connected to the circuit board 3000. For example, the display panel 4000 is disposed on one surface of the COF module 2000. In addition, the circuit board 3000 is disposed on another surface of the COF module 2000.

The COF module 2000 includes a flexible substrate. Accordingly, the display panel 3000 and the circuit board 4000 can have both a rigid form and a bent form. For example, the COF module 2000 includes a bending region BA and can be bent.

The COF module 2000 can be connected in a bent form between the display panel 4000 and the circuit board 3000 which are disposed opposite each other. Therefore, the thickness of the electronic device is reduced. In addition, the design freedom of the electronic device is improved. In addition, a wiring of the COF module 2000 is not broken even in a bent shape. Accordingly, the reliability of the electronic device is improved.

Since the COF module is flexible, it is applied to various electronic devices.

Referring to FIG. 26, the COF module can be applied to a flexible touch window that bends. Accordingly, the touch device including the COF module may be a flexible touch device.

Referring to FIG. 27, the COF module may be applied to various wearable touch devices including a curved display. Accordingly, the wearable touch device may be slimmed down or made lightweight.

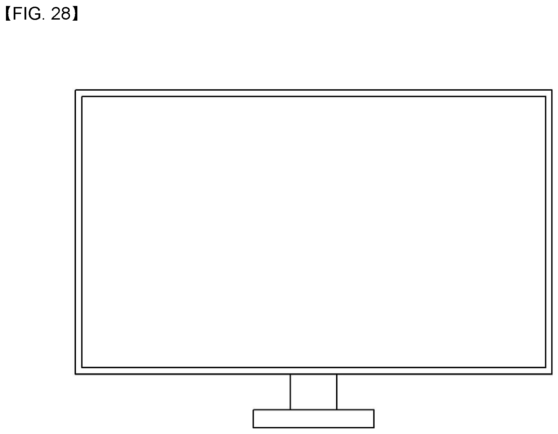

Referring to FIG. 28, the COF module may be applied to various electronic devices having a display portion such as a TV, a monitor, and a laptop.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A flexible circuit board comprising:
a substrate;
a conductive pattern on the substrate; and
a protective layer on the conductive pattern,
wherein the conductive pattern includes a first circuit pattern connected to a circuit board; a second circuit pattern connected to a display panel; and a plurality of outermost patterns,
wherein the plurality of outermost patterns include at least one of a circuit pattern and a dummy pattern,
wherein the substrate includes a first direction in which the display panel and the circuit board face each other and a second direction perpendicular to the first direction,
wherein the plurality of outermost patterns includes a first outermost pattern and a second outermost pattern disposed at an outermost side in the second direction,
wherein the protective layer includes a first end which is one end in the first direction,
wherein the first outermost pattern includes a first protruding portion,
wherein the second outermost pattern includes a third protruding portion, and
wherein the first end overlaps the first protruding portion and the third protruding portion.

2. The flexible circuit board of claim 1, wherein the first circuit pattern includes a first pad part connected to a chip, a second pad part, and a first wiring part connecting the first pad part and the second pad part,
wherein the second circuit pattern includes a third pad part, a fourth pad part, and a second wiring part connecting the third pad part and the fourth pad part,
wherein the first outermost pattern includes a fifth pad part, a sixth pad part, and a third-first wiring part connecting the fifth pad portion and the sixth pad portion, and
wherein the second outermost pattern includes a seventh pad part, an eighth pad part, and a third-second wiring part connecting the seventh pad part and the eighth pad part.

3. The flexible circuit board of claim 2, wherein the protective layer further includes a second end which is another end in the first direction,
wherein the first outermost pattern includes a second protruding portion,
wherein the second outermost pattern includes a fourth protruding portion,
wherein the first protruding portion and the second protruding portion face each other in the first direction,
wherein the third protruding portion and the fourth protruding portion face each other in the first direction, and
wherein the second end overlaps the second protruding portion and the fourth protruding portion.

4. The flexible circuit board of claim 3, wherein the first protruding portion includes a first-first protruding portion, a first-second protruding portion, and a first-third protruding portion,
wherein the second protruding portion includes a second-first protruding portion, a second-second protruding portion, and a second-third protruding portion,
wherein the third protruding portion includes a third-first protruding portion, a third-second protruding portion, and a third-third protruding portion, and
wherein the fourth protruding portion includes a fourth-first protruding portion, a fourth-second protruding portion, and a fourth-third protruding portion.

5. The flexible circuit board of claim 4, wherein the first-first protruding portion is connected to the fifth pad part,
wherein the first-second protruding portion is connected to the third-first wiring part,
wherein the first-third protruding portion is disposed between the first-first protruding portion and the first-second protruding portion,
wherein a distance between the first-first protruding portion and the first-third protruding portion and a distance between the first-second protruding portion and the first-third protruding portion are 50um to 150um, and
wherein the first end overlaps the first-third protruding portion.

6. The flexible circuit board of claim 4, wherein the third-first protruding portion is connected to the seventh pad part,
wherein the third-second protruding portion is connected to the third-second wiring part,
wherein the third-third protruding portion is disposed between the third-first protruding portion and the third-second protruding portion,
wherein a distance between the third-first protruding portion and the third-third protruding portion and a distance between the third-second protruding portion and the third-third protruding portion are 50um to 150um, and
wherein the first end overlaps the third-third protruding portion.

7. The flexible circuit board of claim 4, wherein the second-first protruding portion is connected to the sixth pad part,
wherein the second-second protruding portion is connected to the third-first wiring part,
wherein the second-third protruding portion is disposed between the second-first protruding portion and the second-second protruding portion,
wherein a distance between the second-first protruding portion and the second-third protruding portion and a distance between the second-second protruding portion and the second-third protruding portion are 50um to 150um, and
wherein the second end overlaps the second-third protruding portion.

8. The flexible circuit board of claim 4, wherein the fourth-first protruding portion is connected to the eighth pad part,
wherein the fourth-second protruding portion is connected to the third-second wiring part,
wherein the fourth-third protruding portion is disposed between the fourth-first protruding portion and the fourth-second protruding portion,
wherein a distance between the fourth-first protruding portion and the fourth-third protruding portion and a distance between the fourth-second protruding portion and the fourth-third protruding portion are 50um to 150um, and
wherein the second end overlaps the fourth-third protruding portion.

9. The flexible circuit board of claim 2, wherein the first circuit pattern includes an outermost pattern,
wherein the second circuit pattern includes an outermost pattern,
wherein the outermost pattern of the first circuit pattern includes a fifth protruding portion,
wherein the outermost pattern of the second circuit pattern includes a sixth protruding portion,
wherein the fifth protruding portion includes a fifth-first protruding portion, a fifth-second protruding portion, and a fifth-third protruding portion, and
wherein the sixth protruding portion includes a sixth-first protruding portion, a sixth-second protruding portion, and a sixth-third protruding portion.

10. The flexible circuit board of claim 9, wherein the fifth-first protruding portion is connected to the first pad part,
wherein the fifth-second protruding portion is connected to the first wiring part,
wherein the fifth-third protruding portion is disposed between the fifth-first protruding portion and the fifth-second protruding portion,
wherein the sixth-first protruding portion is connected to the third pad part,
wherein the sixth-second protruding portion is connected to the second wiring part, and
wherein the sixth-third protruding portion is disposed between the sixth-first protruding portion and the sixth-second protruding portion.
